# EUROPEAN PATENT APPLICATION

(11) **EP 4 435 861 A1**
(43) Date of publication of application: **25.09.2024**
(21) Application number: 24164332.9
(22) Date of filing: 19.03.2024
(51) Int. Cl.: H01L 27/12

(54) **DISPLAY APPARATUS**

(30) Priority: 24.03.2023 KR 20230038980; 29.03.2023 KR 20230041539
(71) Applicant: Samsung Display Co., Ltd., Yongin-si, Gyeonggi-do 17113 (KR)
(72) Inventor: Yeo, Inhyeok, 17113 Giheung-gu, Yongin-si (KR); Kim, Kwangmin, 17113 Giheung-gu, Yongin-si (KR); Kim, Kiwook, 17113 Giheung-gu, Yongin-si (KR); Kim, Daehyun, 17113 Giheung-gu, Yongin-si (KR); Shin, Heyjin, 17113 Giheung-gu, Yongin-si (KR); Jin, Changkyu, 17113 Giheung-gu, Yongin-si (KR); Hwang, Doyeon, 17113 Giheung-gu, Yongin-si (KR)
(74) Representative: Dr. Weitzel & Partner

(57) **Abstract**

A display apparatus includes a substrate including a display area and a peripheral area, a first semiconductor layer including a driving unit semiconductor pattern, a first conductive layer disposed on the first semiconductor layer, and including a first capacitor electrode and a second capacitor electrode, a second conductive layer disposed on the first conductive layer, and including a third capacitor electrode overlapping the first capacitor electrode and the second capacitor electrode, a second semiconductor layer disposed on the second conductive layer, and including a first semiconductor pattern overlapping the third capacitor electrode, a third conductive layer disposed on the second semiconductor layer, and including a first electrode pattern overlapping the first semiconductor pattern and the third capacitor electrode, and a fourth conductive layer disposed on the third conductive layer, and including a connection electrode electrically connected to the first semiconductor pattern and the third capacitor electrode.

## Description

### BACKGROUND

### 1. Technical Field

One or more embodiments relate to a display apparatus.

### 2. Description of the Related Art

Recently, display apparatuses have become thinner and lighter, and thus, the range of uses has increased. A display apparatus may include a plurality of pixels, and thin-film transistors, capacitors, and wirings for controlling a luminance of each pixel.

As display apparatuses have become widely used and functions applied or linked to display apparatuses have increased, various types of display apparatuses have been designed.

It is to be understood that this background of the technology section is, in part, intended to provide useful background for understanding the technology. However, this background of the technology section may also include ideas, concepts, or recognitions that were not part of what was known or appreciated by those skilled in the pertinent art prior to a corresponding effective filing date of the subject matter disclosed herein.

### SUMMARY

The invention is defined by the independent claims. The invention discloses a display apparatus having improved display quality. However, the embodiments are examples, and do not limit the scope of the invention.

Additional aspects will be set forth in part in the description which follows and, in part, will be apparent from the description, or may be learned by practice of the presented embodiments.

According to a first aspect of the invention, a display apparatus includes a substrate including a display area and a peripheral area adjacent to the display area; a first semiconductor layer including a driving semiconductor pattern disposed in the peripheral area; a first conductive layer disposed on the first semiconductor layer, and including a first capacitor electrode and a second capacitor electrode disposed in the display area; a second conductive layer disposed on the first conductive layer, and including a third capacitor electrode overlapping the first capacitor electrode and the second capacitor electrode; a second semiconductor layer disposed on the second conductive layer, and including a first semiconductor pattern overlapping the third capacitor electrode; a third conductive layer disposed on the second semiconductor layer, and including a first electrode pattern overlapping the first semiconductor pattern and the third capacitor electrode; and a fourth conductive layer disposed on the third conductive layer, and including a connection electrode electrically connected to the first semiconductor pattern and the third capacitor electrode.

The first electrode pattern may be electrically connected to the first capacitor electrode.

An area where the first semiconductor pattern and the first electrode pattern overlap each other may be disposed inside of the third capacitor electrode in a plan view.

The display apparatus may further include a fifth conductive layer disposed on the fourth conductive layer, and including a first voltage line extending in a first direction, wherein the first conductive layer may include a second voltage line electrically connected to the first voltage line and extending in a second direction intersecting the first direction.

The second capacitor electrode and the second voltage line may be integral.

The first semiconductor layer may include a silicon semiconductor material, and the second semiconductor layer may include an oxide semiconductor material.

One or more insulating layers including an insulating material may be disposed between the first semiconductor layer and the substrate.

According to another aspect of the invention, a display apparatus includes a substrate including a display area and a peripheral area adjacent to the display area; a driving unit transistor disposed in the peripheral area, and including a driving unit semiconductor pattern and a driving unit gate electrode overlapping the driving unit semiconductor pattern; a first transistor disposed in the display area, and including a first semiconductor pattern including a first terminal and a second terminal and a first electrode pattern overlapping the first semiconductor pattern; a second transistor electrically connected to the first electrode pattern of the first transistor and a data line; a third transistor electrically connected to the first electrode pattern of the first transistor and a reference voltage line; a fourth transistor electrically connected to the first terminal of the first transistor and a driving voltage line; a storage capacitor including a first capacitor electrode electrically connected to the first electrode pattern of the first transistor; and a third capacitor electrode electrically connected to the second terminal of the first transistor and overlapping the first electrode pattern of the first transistor; and a hold capacitor including a second capacitor electrode and the third capacitor electrode, wherein the third capacitor electrode is disposed on an insulating layer covering the driving semiconductor pattern.

An area where the first semiconductor pattern and the first electrode pattern overlap each other may be disposed inside of the third capacitor electrode in a plan view.

The driving voltage line may include a first voltage line extending in a first direction and a second voltage line extending in a second direction intersecting the first direction, wherein the second voltage line and the second capacitor electrode are integral. The first voltage line may also be called as first driving voltage line and the second voltage line may also be called as second driving voltage line.

The driving unit gate electrode and the first capacitor electrode and the second capacitor electrode may be disposed in a same layer.

The third capacitor electrode may be disposed on the first capacitor electrode and the second capacitor electrode, wherein the third capacitor electrode overlaps the first capacitor electrode and the second capacitor electrode.

The display apparatus may further include a connection electrode that electrically connects the second terminal of the first transistor to the third capacitor electrode.

The connection electrode may overlap the first electrode pattern.

The display apparatus may further include a fifth transistor electrically connected between a first initialization voltage line and the second terminal of the first transistor.

The display apparatus may further include an organic light-emitting diode including a pixel electrode, a counter electrode, and an intermediate layer disposed between the pixel electrode and the counter electrode, and a sixth transistor electrically connected between the second terminal of the first transistor and the organic light-emitting diode.

The display apparatus may further include a seventh transistor electrically connected between the organic light-emitting diode and a second initialization voltage line.

The driving unit semiconductor pattern may include a silicon semiconductor material, and the first semiconductor pattern may include an oxide semiconductor material.

One or more insulating layers including an insulating material may be disposed between the driving unit semiconductor pattern and the substrate.

The second capacitor electrode may be electrically connected to the reference voltage line.

Other aspects, features, and advantages of the invention will become more apparent from the drawings, the claims, and the detailed description.

### BRIEF DESCRIPTION OF THE DRAWINGS

The above and other aspects, features, and advantages of embodiments will be more apparent from the following description taken in conjunction with the accompanying drawings, in which:
FIGS. 1A and 1B are schematic plan views schematically illustrating a display apparatus, according to an embodiment;
FIG. 2 is a view schematically illustrating a display apparatus, according to an embodiment;
FIGS. 3A and 3B are diagrams for describing a method of driving a display apparatus according to a driving frequency;
FIG. 4 is a schematic cross-sectional view schematically illustrating a display apparatus, according to an embodiment;
FIGS. 5A and 5B are schematic diagrams of equivalent circuits illustrating a pixel included in a display apparatus, according to an embodiment;
FIGS. 6A and 6B are schematic diagrams schematically illustrating signals for describing an operation of the pixel of FIG. 5A;
FIG. 7 is a view schematically illustrating an arrangement of a portion of a display apparatus, according to an embodiment;
FIGS. 8 to 13 are views schematically illustrating an arrangement of a portion of the display apparatus of FIG. 7 for each layer;
FIG. 14 is a view schematically illustrating an arrangement of a number of layers of the display apparatus of FIG. 7;
FIG. 15 is a schematic cross-sectional view schematically illustrating the display apparatus of FIG. 7, taken along line I-I';
FIGS. 16A and 16B are schematic diagrams of equivalent circuits illustrating a pixel included in a display apparatus, according to an embodiment;
FIGS. 17A to 18B are schematic cross-sectional views illustrating a structure of an organic light-emitting diode included in a display apparatus, according to an embodiment; and
FIG. 19 is a schematic cross-sectional view illustrating structures of organic light-emitting diodes included in a display apparatus, according to an embodiment.

### DETAILED DESCRIPTION OF THE EMBODIMENTS

Reference will now be made in detail to embodiments, examples of which are illustrated in the accompanying drawings, wherein like reference numerals refer to like elements throughout. In this regard, the embodiments may have different forms and should not be construed as being limited to the descriptions set forth herein. Accordingly, the embodiments are described below, by referring to the figures, to explain aspects of the description.

As used herein, the term "and/or" includes any and all combinations of one or more of the associated listed items.

Throughout the invention, the expression "at least one of a, b or c" indicates only a, only b, only c, both a and b, both a and c, both b and c, all of a, b, and c, or variations thereof.

As the invention allows for various changes and numerous embodiments, embodiments will be illustrated in the drawings and described in the detailed description. Effects and features of the invention, and methods for achieving them will be clarified with reference to embodiments described below in detail with reference to the drawings. However, the invention is not limited to the following embodiments and may be embodied in various forms.

Hereinafter, embodiments will be described in detail with reference to the accompanying drawings, wherein the same or corresponding elements are denoted by the same reference numerals throughout and a repeated description thereof is omitted.

It will be understood that, although the terms first, second, etc., may be used herein to describe various elements, these elements should not be limited by these terms. These terms are only used to distinguish one element from another element. For example, a first element may be referred to as a second element, and similarly, a second element may be referred to as a first element without departing from the scope of the invention.

The singular forms "a," "an," and "the" as used herein are intended to include the plural forms as well unless the context clearly indicates differently.

It will be understood that the terms "comprises," "comprising," "includes," and/or "including,", "has," "have," and/or "having," and variations thereof when used in this specification, specify the presence of stated features, integers, steps, operations, elements, components, and/or groups thereof, but do not preclude the presence or addition of one or more other features, integers, steps, operations, elements, components, and/or groups thereof.

It will be further understood that, when a layer, region, or component is referred to as being "on" another layer, region, or component, it may be directly on the other layer, region, or component, or may be indirectly on the other layer, region, or component with intervening layers, regions, or components therebetween.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

When an element is described as 'not overlapping' or 'to not overlap' another element, this may include that the elements are spaced apart from each other, offset from each other, or set aside from each other or any other suitable term as would be appreciated and understood by those of ordinary skill in the art.

In the specification, it will be understood that when a layer, an area, or a component is referred to as being "connected" to another layer, area, or component, it may be "directly connected" to the other layer, area, or component and/or may be "indirectly connected" to the other layer, area, or component with other layers, areas, or components interposed therebetween. For example, when a layer, an area, or a component is referred to as being "electrically connected," it may be directly electrically connected, and/or may be indirectly electrically connected with intervening layers, areas, or components therebetween.

"A and/or B" is used herein to select only A, select only B, or select both A and B. "At least one of A and B" is used to select only A, select only B, or select both A and B.

When A and B are connected to each other in the following embodiments, it may include cases where A and B are electrically connected to each other, A and B are functionally connected to each other, and A and B are directly connected to each other. A and B may be objects (for example, apparatuses, devices, circuits, wirings, electrodes, terminals, conductive films, and layers). Accordingly, a connection relationship is not limited to a given connection relationship, for example, a connection relationship shown in the drawings or the detailed description, and may include anything other than the connection relationship shown in the drawings or the detailed description.

For example, when A and B are electrically connected, one or more elements (for example, switches, transistors, capacitors, inductors, resistors, or diodes) that enable electrical connection between A and B may be connected between A and B.

In the following embodiments, "on" used in association with a device state may refer to a state in which a device is activated, and "off" may refer to a state in which a device is deactivated. "on" used in association with a signal received by a device may refer to a signal for activating a device, and "off" may refer to a signal for deactivating a device. A device may be activated by a high-level voltage or a low-level voltage. For example, a P-channel transistor (P-type transistor) is activated by a low-level voltage, and an N-channel transistor (N-type transistor) is activated by a high-level voltage. Accordingly, it should be understood that "on" voltages for the P-type transistor and the N-type transistor have opposite (high and low) voltage levels.

In the specification, when an arbitrary signal is applied, it may mean that an on voltage (for example, a high-level voltage) is applied, and when an arbitrary signal is not applied, it may mean that an off voltage (for example, a low-level voltage) is applied.

In the following embodiments, the x-axis (an x-direction), the y-axis (a y-direction) and the z-axis (a z-direction) are not limited to three axes of the rectangular coordinate system, and may be interpreted in a broader sense. For example, the x-axis (the x-direction), the y-axis (the y-direction), and the z-axis (the z-direction) may be perpendicular to one another, or may represent different directions that are not perpendicular to one another.

When an embodiment may be implemented differently, a specific process order may be different from the described order. For example, two consecutively described processes may be performed substantially at the same time or may be performed in an order opposite to the described order.

Sizes of components in the drawings may be exaggerated or contracted for convenience of explanation. For example, because sizes and thicknesses of elements in the drawings are arbitrarily illustrated for convenience of explanation, the invention is not limited thereto.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

Unless otherwise defined or implied herein, all terms (including technical and scientific terms) used herein have the same meaning as commonly understood by one of ordinary skill in the art to which the invention pertains. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

A display apparatus according to embodiments may be implemented as an electronic device such as a smartphone, a mobile phone, a smart watch, a navigation device, a game console, a TV, a vehicle head unit, a notebook computer, a laptop computer, a tablet computer, a personal media player (PMP), or a personal digital assistant (PDA). Also, the display apparatus may be a flexible apparatus.

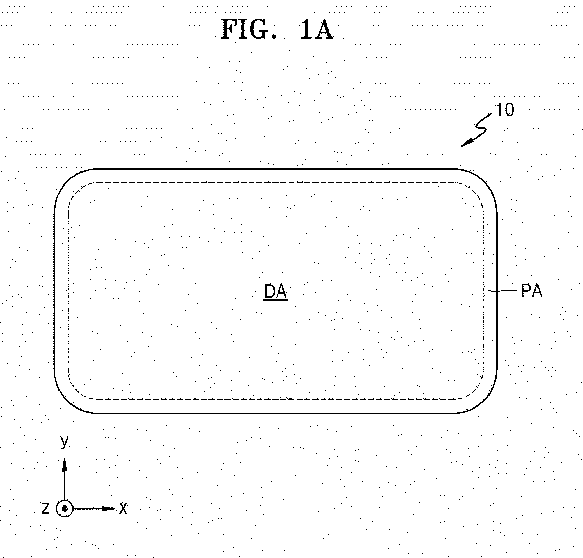

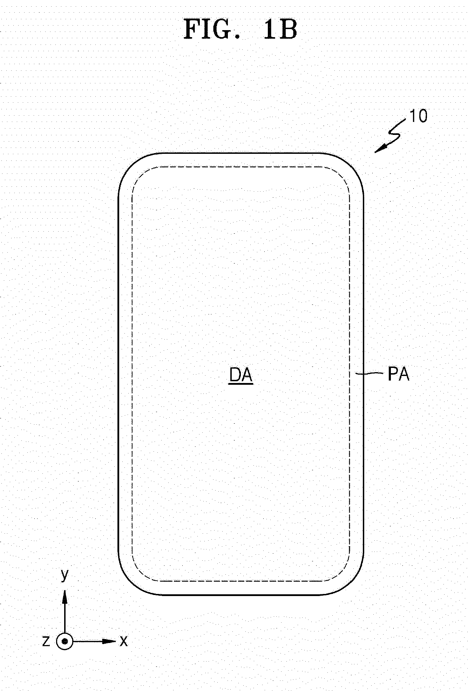

FIGS. 1A and 1B are schematic plan views schematically illustrating a display apparatus, according to an embodiment.

Referring to FIGS. 1A and 1B, a display apparatus 10 may include a display area DA where an image is displayed and a peripheral area PA outside the display area DA. The peripheral area PA may surround or may be adjacent to at least a part of the display area DA.

In a plan view, the display area DA may have a rectangular shape. In an embodiment, the display area DA may have a polygonal shape (for example, a triangular shape, a pentagonal shape, or a hexagonal shape), a circular shape, an elliptical shape, or an irregular shape. The display area DA may have a shape with round corners.

In an embodiment, the display apparatus 10 may include the display area DA having a shape in which a length in an x-direction is greater than a length in a y-direction as shown in FIG. 1A. In an embodiment, the display apparatus 10 may include the display area DA having a shape in which a length in the y-direction is greater than a length in the x-direction as shown in FIG. 1B.

In an embodiment, the peripheral area PA may be a non-display area where pixels are not located (or disposed). In the peripheral area PA, various conductive lines for transmitting an electrical signal to be applied to the display area DA, outer circuits electrically connected to pixel circuits, and pads to which a printed circuit board or a driver integrated circuit (IC) chip is attached may be located. The pads located in the peripheral area PA may be exposed without being covered by an insulating layer, and may be electrically connected to the printed circuit board or the driver IC chip.

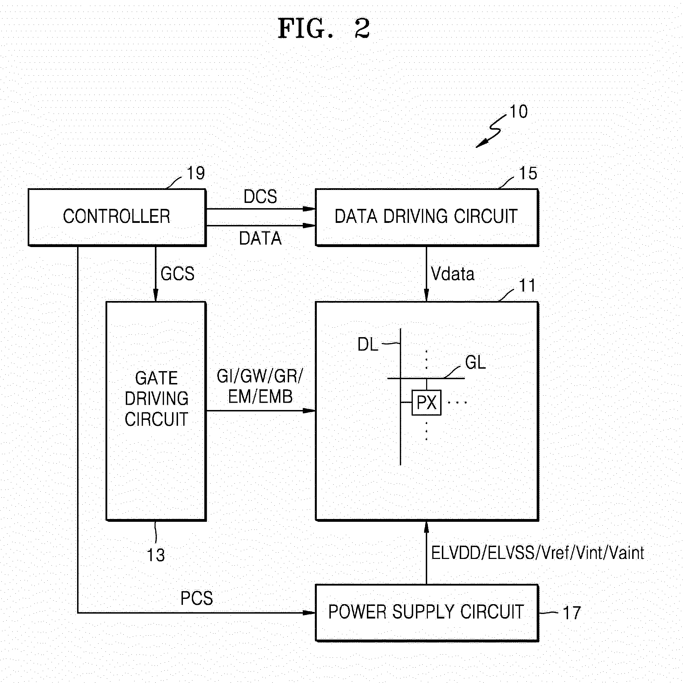

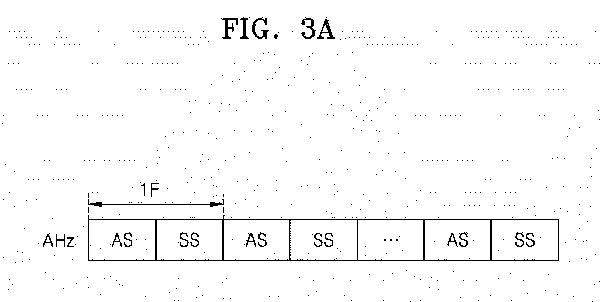

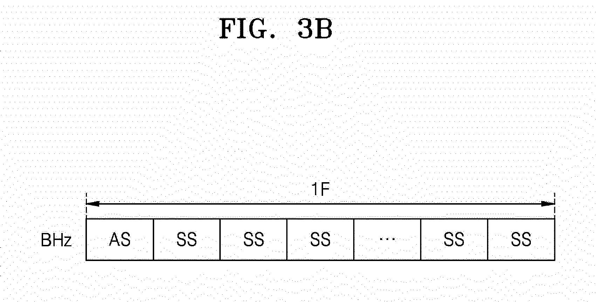

FIG. 2 is a view schematically illustrating a display apparatus, according to an embodiment. FIGS. 3A and 3B are diagrams for describing a method of driving a display apparatus according to a driving frequency.

Referring to FIG. 2, the display apparatus 10 according to an embodiment may include a pixel unit 11, a gate driving circuit 13, a data driving circuit 15, a power supply circuit 17, and a controller 19.

The pixel unit 11 may be provided in the display area DA (see FIGS. 1A and 1B). The gate driving circuit 13, the data driving circuit 15, the power supply circuit 17, and the controller 19 may be provided in the peripheral area PA (see FIGS. 1A and 1B).

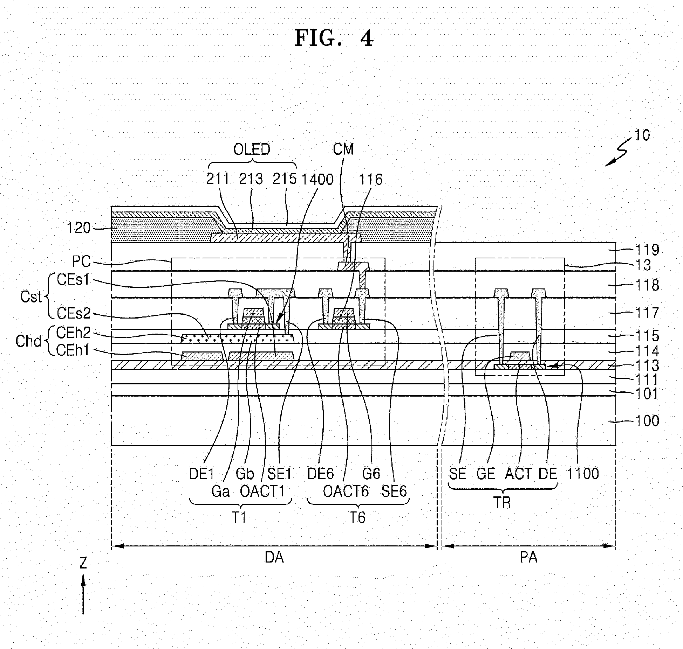

As shown in FIG. 2, in the pixel unit 11, a plurality of gate lines GL, a plurality of data lines DL, and a plurality of pixels PX connected to the gate lines GL and the data lines DL may be located. The plurality of pixels PX may be located in any of various arrangements such as a stripe arrangement, a PENTILE^{™} arrangement, DIAMOND PIXEL ^{™} arrangement, or a mosaic arrangement, to display an image. Each pixel PX may include an organic light-emitting diode OLED (e.g. refer to FIG. 4) as a display element (light-emitting device), and the organic light-emitting diode OLED may be connected to a pixel circuit. The pixel circuit may include a plurality of transistors and at least one capacitor. Each pixel PX may emit light, for example, red light, green light, blue light, or white light, through the organic light-emitting diode OLED. Each pixel PX may be connected to at least one corresponding gate line from among the plurality of gate lines GL and a corresponding data line from among the plurality of data lines DL.

Each of the data lines DL may extend in a first direction (column direction) and may be connected to the pixels PX located in the same column. The data line DL may transmit a data signal to each of the pixels PX in the same column in synchronization with the gate signal. Each of the gate lines GL may extend in a second direction (row direction) and may be connected to the pixels PX located in the same row. The gate line GL may transmit a gate signal to the pixels PX in the same row.

The gate driving circuit 13 may be connected to the plurality of gate lines GL, may generate gate signals (for example, a second gate signal GI, a first gate signal GW, a third gate signal GR, a fourth gate signal EM, and a fifth gate signal EMB) in response to a control signal GCS from the controller 19, and may sequentially supply the gate signals to the gate lines GL. The gate line GL may be connected to a gate of a transistor included in the pixel PX. A gate signal may be a gate control signal for controlling to turn on or turn off the transistor whose gate is connected to the gate line GL. The gate signal may be a square wave signal including an on voltage for turning on the transistor and an off voltage for turning off the transistor. In an embodiment, the on voltage may be a high-level voltage (first-level voltage) or a low-level voltage (second-level voltage).

Although the pixel PX is connected to one gate line GL in FIG. 2, this is merely an example, and the pixel PX may be connected to two or more gate lines, and the gate driving circuit 13 may supply two or more gate signals having different timings at which an on voltage is applied to the gate lines. For example, the pixel PX may be connected to first to fifth gate lines, and the gate driving circuit 13 may respectively apply a first gate signal GW, a second gate signal GI, a third gate signal GR, a fourth gate signal EM, and a fifth gate signal EMB to the first gate lines, the second gate lines, the third gate lines, the fourth gate lines, and the fifth gate lines.

The data driving circuit 15 may be connected to the plurality of data lines DL, and may supply a data signal to the data lines DL in response to a control signal DCS from the controller 19. The data signal supplied to the data line DL may be supplied to the pixel PX to which the gate signal is supplied. The data driving circuit 15 may convert input image data DATA having a gray level input from the controller 19 into a data signal in the form of a voltage or current. FIG. 2 illustrates an example where the data driving circuit 15 outputs a data signal Vdata in the form of a voltage.

The power supply circuit 17 may generate voltages required to drive the pixel PX in response to a control signal PCS from the controller 19. The power supply circuit 17 may generate a first driving voltage ELVDD and a second driving voltage ELVSS and may supply the first driving voltage ELVDD and the second driving voltage ELVSS to the pixels PX. The first driving voltage ELVDD may be a high-level voltage provided to a first electrode (pixel electrode or anode) of a display element included in the pixel PX. The second driving voltage ELVSS may be a low-level voltage provided to a second electrode (counter electrode or cathode) of the display element included in the pixel PX. The power supply circuit 17 may generate a reference voltage Vref, a first initialization voltage Vint, and a second initialization voltage Vaint and may supply the reference voltage Vref, the first initialization voltage Vint, and the second initialization voltage Vaint to the pixels PX.

A voltage level of the first driving voltage ELVDD may be higher than a voltage level of the second driving voltage ELVSS. A voltage level of the reference voltage Vref may be lower than a voltage level of the first driving voltage ELVDD. A voltage level of the first initialization voltage Vint may be lower than a voltage level of the second driving voltage ELVSS. A voltage level of the second initialization voltage Vaint may be higher than a voltage level of the first initialization voltage Vint. A voltage level of the second initialization voltage Vaint may be equal to or higher than a voltage level of the second driving voltage ELVSS.

The controller 19 may generate the control signals GCS, DCS, and PCS based on signals input from the outside, and may supply the control signals GCS, DCS, and PCS to the gate driving circuit 13, the data driving circuit 15, and the power supply circuit 17. The control signal GCS output to the gate driving circuit 13 may include a plurality of clock signals and a gate start signal. The control signal DCS output to the data driving circuit 15 may include a source start signal and clock signals.

The display apparatus 10 may include a display panel, and the display panel may include a substrate. Because the display panel may include the substrate, it may be said that the substrate may include the display area DA (see FIGS. 1A and 1B) and the peripheral area PA (see FIGS. 1A and 1B). The pixels PX may be located in the display area DA of the substrate. A part or the whole of the gate driving circuit 13 may be directly formed in the peripheral area PA of the substrate during a process of forming a transistor constituting a pixel circuit in the display area DA of the substrate. The data driving circuit 15, the power supply circuit 17, and the controller 19 may each be formed as a separate integrated circuit chip or one integrated circuit chip and may be located on a flexible printed circuit board (FPCB) electrically connected to a pad located on a side of the substrate. In an embodiment, the data driving circuit 15, the power supply circuit 17, and the controller 19 may be directly located on the substrate by using a chip-on-glass (COG) or chip-on-plastic (COP) manner.

In an embodiment, a plurality of transistors included in a pixel circuit located in the display area DA (see FIGS. 1A and 1B) may be N-type oxide thin-film transistors, and a plurality of transistors included in the gate driving circuit 13 located in the peripheral area PA (see FIGS. 1A and 1B) may be P-type silicon thin-film transistors.

The oxide thin-film transistor may be a low temperature polycrystalline oxide (LTPO) thin-film transistor in which an active pattern (semiconductor layer) may include an oxide. However, this is merely an example, and the N-type transistors are not limited thereto. For example, an active pattern (semiconductor layer) included in the N-type transistor may include an inorganic semiconductor (for example, amorphous silicon or polysilicon) or an organic semiconductor.

The silicon thin-film transistor may be a low temperature polysilicon (LTPS) thin-film transistor in which an active pattern (semiconductor layer) may include amorphous silicon or polysilicon.

Because the plurality of transistors included in the pixel circuit are oxide thin-film transistors, problems such as IR interference caused by a small bandgap of LTPS thin-film transistor may be prevented or reduced. Also, because the plurality of transistors included in the gate driving circuit 13 are LTPS thin-film transistors with high electron mobility, the area of a non-display area of the display apparatus 10 may be reduced.

In an embodiment, some or a number of the plurality of transistors included in the pixel circuit may be N-type oxide thin-film transistors, and others may be P-type silicon thin-film transistors.

The display apparatus 10 may support a variable refresh rate (VRR). A refresh rate is a frequency at which a data signal is actually written to the driving transistor of the pixel PX, is also referred to as a screen scan rate or a screen refresh rate, and may represent the number of image frames reproduced for one second.

In an embodiment, a refresh rate may be an output frequency of the gate driving circuit 13 and/or the data driving circuit 15. A frequency corresponding to the refresh rate may be a driving frequency. The display apparatus 10 may adjust an output frequency of the gate driving circuit 13 and a corresponding output frequency of the data driving circuit 15 according to the driving frequency. The display apparatus 10 supporting a VRR may operate by changing the driving frequency within a range of a maximum driving frequency and a minimum driving frequency. For example, in case that a refresh rate is about 60 Hz, a gate signal for writing a data signal from the gate driving circuit 13 may be supplied to each horizontal line (row) 60 times per second.

According to a driving frequency, one frame 1F may include a first scan period AS and one or more second scan periods SS. For example, as shown in FIG. 3A, in the display apparatus 10 operating at a driving frequency of AHz, one frame 1F may include one first scan period AS and one second scan period SS. As shown in FIG. 3B, in the display apparatus 10 operating at a driving frequency of BHz lower than the driving frequency of AHz, one frame 1F may include one first scan period AS and two or more second scan periods SS. As a driving frequency is lower, one frame 1F may be longer. In an embodiment, one frame 1F may include only one first scan period AS.

The first scan period AS may be defined as an address scan period in which a data signal is written to the pixel PX in response to the first gate signal GW and thus, the pixel PX emits light. An operation of writing a data signal to the pixel PX from the data line DL may also be referred to as a data programming operation. The second scan period SS may be defined as a self-scan period in which the first gate signal GW is not applied to the pixel PX and thus, a data signal is not written. During the second scan period SS, the data signal written in the first scan period AS may be maintained, and the pixel PX may emit light. A length of the second scan period SS may be the same as a length of the first scan period AS.

FIG. 4 is a schematic cross-sectional view schematically illustrating a display apparatus, according to an embodiment.

Referring to FIG. 4, the display apparatus 10 may include a substrate 100. The substrate 100 may include the display area DA and the peripheral area PA outside the display area DA. In the display area DA, an organic light-emitting diode OLED as a display element and a pixel circuit PC electrically connected to the organic light-emitting diode OLED may be located. In the peripheral area PA, the gate driving circuit 13 may be located.

The substrate 100 may include a glass material, a ceramic material, or a metal material. The substrate 100 may include a flexible or bendable material. In case that the substrate 100 is flexible or bendable, the substrate 100 may include a polymer resin such as a polyethersulfone, polyacrylate, polyetherimide, polyethylene naphthalate, polyethylene terephthalate, polyphenylene sulfide, polyarylate, polyimide, polycarbonate, or cellulose acetate propionate.

The substrate 100 may have a single or multi-layer structure including the above material. In case that the substrate 100 has a multi-layer structure, the substrate 100 may further include an inorganic layer located between organic layers including a polymer resin.

A barrier layer 101 may be located on the substrate 100. The barrier layer 101 may prevent or minimize penetration of impurities from the bottom of the substrate 100. The barrier layer 101 may have single or multi-layer structure including an inorganic material such as silicon nitride (SiNₓ) or silicon oxide (SiOₓ).

A first insulating layer 111 may be located on the barrier layer 101, and the gate driving circuit 13 and the pixel circuit PC may be located on the first insulating layer 111. The gate driving circuit 13 may be located in the peripheral area PA, and the pixel circuit PC may be located in the display area DA. The gate driving circuit 13 and the pixel circuit PC may include transistors. In FIG. 4, the pixel circuit PC may include a first transistor T1 and a sixth transistor T6, and the gate driving circuit 13 may include a driving unit or driving transistor TR.

The driving unit transistor TR may be located in the peripheral area PA, and may include a driving unit semiconductor pattern ACT, a driving unit or driving gate electrode GE, a source electrode SE, and a drain electrode DE.

The driving unit semiconductor pattern ACT may be included in a first semiconductor layer 1100 located on the first insulating layer 111. The driving unit semiconductor pattern ACT may include a silicon-based semiconductor material such as polysilicon. The driving unit semiconductor pattern ACT may include a channel region overlapping the driving unit gate electrode GE and a source region and a drain region located on both sides of the channel region. The source region and the drain region may include impurities having a higher concentration than the channel region.

A second insulating layer 113 may be located on the first insulating layer 111 to cover the driving unit semiconductor pattern ACT. The driving unit gate electrode GE may be located on the second insulating layer 113. The driving unit gate electrode GE may include a conductive material such as molybdenum (Mo), aluminum (Al), copper (Cu), or titanium (Ti), and may have a single or multi-layer structure including the above material.

Only an insulating layer including an insulating material may be located between the driving unit semiconductor pattern ACT and the substrate 100. In other words, only an insulating layer including an insulating material may be located between the first semiconductor layer 1100 and the substrate 100. For example, between the driving unit semiconductor pattern ACT and the substrate 100, the barrier layer 101 and the first insulating layer 111 may be located as shown in FIG. 4, and a conductive layer including a metal material may not be located.

A third insulating layer 114, a fourth insulating layer 115, and a fifth insulating layer 117 may be sequentially stacked each other on the second insulating layer 113 to cover the driving unit gate electrode GE. The source electrode SE and the drain electrode DE of the driving unit transistor TR may be located on the fifth insulating layer 117. The source electrode SE of the driving unit transistor TR may be connected to the source region of the driving unit transistor TR through a contact hole formed in the second insulating layer 113, the third insulating layer 114, the fourth insulating layer 115, and the fifth insulating layer 117, and the drain electrode DE of the driving unit transistor TR may be connected to the drain region of the driving unit transistor TR through a contact hole formed in the second insulating layer 113, the third insulating layer 114, the fourth insulating layer 115, and the fifth insulating layer 117.

Each of the source electrode SE and the drain electrode DE of the driving unit transistor TR may include a conductive material such as Mo, Al, Cu, or Ti, and may have a single or multi-layer structure including the above material.

The pixel circuit PC may be located in the display area DA, and may include a plurality of transistors, a storage capacitor Cst, and a hold capacitor Chd. In FIG. 4, for example, the pixel circuit PC may include the first transistor T1 that is a driving transistor and the sixth transistor T6 that is a switching transistor. In an embodiment, the sixth transistor T6 may be omitted.

First, a first electrode CEs1 of the storage capacitor Cst and a third electrode CEh1 of the hold capacitor Chd may be located on the second insulating layer 113. The first electrode CEs1 and the third electrode CEh1 may be located in the same layer as the driving unit gate electrode GE of the driving unit transistor TR.

A second electrode CEs2 of the storage capacitor Cst and a fourth electrode CEh2 of the hold capacitor Chd may be located on the third insulating layer 114 covering the first electrode CEs1 and the third electrode CEh1. The second electrode CEs2 may overlap the first electrode CEs1 of the storage capacitor Cst, and the fourth electrode CEh2 may overlap the third electrode CEh1 of the hold capacitor Chd. The second electrode CEs2 and the fourth electrode CEh2 may function as a lower gate electrode Gb of the first transistor T1 in an area overlapping a first oxide semiconductor pattern OACT1 of the first transistor T1. In an embodiment, the lower gate electrode Gb of the first transistor T1, the second electrode CEs2 of the storage capacitor Cst, and the fourth electrode CEh2 of the hold capacitor Chd may be integrally provided to function as a source sync back gate.

Each of the first electrode CEs1, the second electrode CEs2, the third electrode CEh1, and the fourth electrode CEh2 may include a conductive material such as Mo, Al, Cu, or Ti, and may have a single or multi-layer structure including the above material.

The first oxide semiconductor pattern OACT1 and a second oxide semiconductor pattern OACT6 may be located on the fourth insulating layer 115 covering the second electrode CEs2 and the fourth electrode CEh2. The first oxide semiconductor pattern OACT1 and the second oxide semiconductor pattern OACT6 may be included in a second semiconductor layer 1400 located on the fourth insulating layer 115. The pixel circuit PC may further include a transistor in addition to the first transistor T1 and the sixth transistor T6 of FIG. 4. Transistors included in the pixel circuit PC may all be oxide thin-film transistors including an oxide semiconductor pattern included in the second semiconductor layer 1400.

The second semiconductor layer 1400 may include an oxide-based semiconductor material, for example, at least one oxide selected from the group consisting of indium (In), gallium (Ga), stannum (Sn), zirconium (Zr), vanadium (V), hafnium (Hf), cadmium (Cd), germanium (Ge), chromium (Cr), titanium (Ti), aluminum (Al), cesium (Cs), cerium (Ce), and zinc (Zn).

Because the oxide semiconductor material has a wide bandgap and low leakage current, even in case that a driving time of a transistor is long, a voltage drop is not large, and thus, a luminance change caused by a voltage drop is not large even during low-frequency driving.

The first oxide semiconductor pattern OACT1 may include a channel region overlapping an upper gate electrode Ga of the first transistor T1 and a source region and a drain region located on both sides of the channel region. Similarly, the second oxide semiconductor pattern OACT6 may include a channel region overlapping a gate electrode G6 of the sixth transistor T6 and a source region and a drain region located on both sides of the channel region.

A part of the first oxide semiconductor pattern OACT1, for example, at least the channel region of the first transistor T1, may overlap the storage capacitor Cst and the hold capacitor Chd. The first electrode CEs1 and the second electrode CEs2 of the storage capacitor Cst and the third electrode CEh1 and the fourth electrode CEh2 of the hold capacitor Chd may be located between the first semiconductor layer 1100 and the second semiconductor layer 1400.

In a plan view, the channel region of the first transistor T1 may be located inside the second electrode CEs2 and the fourth electrode CEh2. In other words, in a plan view, an area where the first oxide semiconductor pattern OACT1 overlaps the upper gate electrode Ga may be located inside the second electrode CEs2 and the fourth electrode CEh2.

The second electrode CEs2 and the fourth electrode CEh2 may prevent device characteristics of the first transistor T1 from being changed due to photocurrent caused in the channel region of the first transistor T1 by external light incident on the substrate 100. For example, because the first transistor T1, and the storage capacitor Cst and the hold capacitor Chd overlap each other, a lower metal layer formed under or below the channel region of the first transistor T1 to block light may be omitted.

The first electrode CEs1 of the storage capacitor Cst and the third electrode CEh1 of the hold capacitor Chd may be provided in the same layer as the driving unit gate electrode GE of the driving unit transistor TR is located. Accordingly, because a separate conductive layer for forming electrodes of the storage capacitor Cst and the hold capacitor Chd does not need to be formed, the number of masks may be reduced and a process of manufacturing the display apparatus 10 may be further simplified.

Also, as a physical distance between the first electrode CEs1 and the second electrode CEs2 of the storage capacitor Cst decreases and a storage capacitance increases, the storage capacitor Cst may be formed in a narrower area.

The upper gate electrode Ga may be located on the first oxide semiconductor pattern OACT1, and the gate electrode G6 of the sixth transistor T6 may be located on the second oxide semiconductor pattern OACT6. Each of the upper gate electrode Ga of the first transistor T1 and the gate electrode G6 of the sixth transistor T6 may include a conductive material such as Mo, Al, Cu, or Ti, and may have a single or multi-layer structure including the above material.

A sixth insulating layer 116 may be located between the upper gate electrode Ga of the first transistor T1 and the first oxide semiconductor pattern OACT1 and between the gate electrode G6 of the sixth transistor T6 and the second oxide semiconductor pattern OACT6. In an embodiment, the sixth insulating layer 116 may be formed by being patterned by using the upper gate electrode Ga of the first transistor T1 and the gate electrode G6 of the sixth transistor T6 as a mask. Accordingly, the sixth insulating layer 116 may overlap the upper gate electrode Ga of the first transistor T1 and the gate electrode G6 of the sixth transistor T6, and may have a shape corresponding to that of each of the upper gate electrode Ga and the gate electrode G6. In an embodiment, the sixth insulating layer 116 may be formed on an entire surface of the substrate 100.

A source electrode SE1 and a drain electrode DE1 of the first transistor T1 and a source electrode SE6 and a drain electrode DE6 of the sixth transistor T6 may be located on the fifth insulating layer 117 covering the upper gate electrode Ga of the first transistor T1 and the gate electrode G6 of the sixth transistor T6. Each of the source electrode SE1 and the drain electrode DE1 of the first transistor T1 and the source electrode SE6 and the drain electrode DE6 of the sixth transistor T6 may include a conductive material such as Mo, Al, Cu, or Ti, and may have a single or multi-layer structure including the above material.

The source electrode SE1 of the first transistor T1 may be connected to the source region of the first transistor T1 through a contact hole formed in the fifth insulating layer 117, and may be connected to a lower gate electrode Gb of the first transistor T1, the second electrode CEs2 of the storage capacitor Cst and the fourth electrode CEh2 of the hold capacitor Chd through a contact hole formed in the fourth insulating layer 115 and the fifth insulating layer 117. The drain electrode DE1 of the first transistor T1 may be connected to the drain region of the first transistor T1 through a contact hole formed in the fifth insulating layer 117. In an embodiment, the drain electrode DE1 may be omitted.

The source electrode SE6 of the sixth transistor T6 may be connected to a source region of the sixth transistor T6 through a contact hole formed in the fifth insulating layer 117, and the drain electrode DE6 of the sixth transistor T6 may be connected to a drain region of the sixth transistor T6 through a contact hole formed in the fifth insulating layer 117.

A seventh insulating layer 118 may be located on the fifth insulating layer 117 to cover the source electrode SE1 and the drain electrode DE1 of the first transistor T1, the source electrode SE6 and the drain electrode DE6 of the sixth transistor T6, and the source electrode SE and the drain electrode DE of the driving unit transistor TR.

A pixel connection electrode CM may be located on the seventh insulating layer 118. The pixel connection electrode CM may be connected to the source electrode SE6 of the sixth transistor T6 through a contact hole formed in the seventh insulating layer 118. For example, the pixel connection electrode CM may connect a pixel electrode 211 of the organic light-emitting diode OLED to the source electrode SE6 of the sixth transistor T6. The pixel connection electrode CM may include a conductive material such as Mo, Al, Cu, or Ti, and may have a single or multi-layer structure including the above material.

An eighth insulating layer 119 may be located on the seventh insulating layer 118 to cover the pixel connection electrode CM. In an embodiment, the first insulating layer 111, the second insulating layer 113, the third insulating layer 114, the fourth insulating layer 115, the fifth insulating layer 117, and the sixth insulating layer 116 may be inorganic insulating layers, and the seventh insulating layer 118 and the eighth insulating layer 119 may be organic insulating layers. The inorganic insulating layer may include an inorganic material including an oxide or a nitride. For example, the inorganic insulating layer may include at least one of silicon oxide (SiO₂), silicon nitride (SiNₓ), silicon oxynitride (SiOₓN_{y}), aluminum oxide (Al₂O₃), titanium oxide (TiO₂), tantalum oxide (Ta₂O₅), hafnium oxide (HfO₂), and zinc oxide (ZnO₂). The organic insulating layer may include an organic material such as acryl, benzocyclobutene (BCB), polyimide, or hexamethyldisiloxane (HMDSO).

A pixel-defining film 120 and the organic light-emitting diode OLED may be located on the eighth insulating layer 119. The pixel-defining film 120 and the organic light-emitting diode OLED may be located in the display area DA.

The organic light-emitting diode OLED may include the pixel electrode 211 (first electrode or anode), a counter electrode 215 (second electrode or cathode), and an intermediate layer 213 located between the pixel electrode 211 and the counter electrode 215.

The pixel electrode 211 may be located on the eighth insulating layer 119. The pixel electrode 211 may be a (semi)transmissive electrode or a reflective electrode. In embodiments, the pixel electrode 211 may include a reflective layer formed of Ag, Mg, Al, Pt, Pd, Au, Ni, Nd, Ir, Cr, or a compound thereof, and a transparent or semi-transparent electrode layer formed on the reflective layer. The transparent or semi-transparent electrode layer may include at least one selected from the group consisting of indium tin oxide (ITO), indium zinc oxide (IZO), zinc oxide (ZnO), indium oxide (In₂O₃), indium gallium oxide (IGO), and aluminum zinc oxide (AZO). In embodiments, the pixel electrode 211 may include ITO/Ag/ITO.

The pixel-defining film 120 may be located on the eighth insulating layer 119 to cover an edge of the pixel electrode 211. The pixel-defining film 120 may define an opening through which a central portion of the pixel electrode 211 is exposed. An emission area of the organic light-emitting diode OLED may be defined by the opening.

Because the pixel-defining film 120 increases a distance between the edge of the pixel electrode 211 and the counter electrode 215, an arc or the like may be prevented from occurring at the edge of the pixel electrode 211. The pixel-defining film 120 may be formed of at least one organic insulating material selected from the group consisting of polyimide, polyamide, acrylic resin, BCB, and phenolic resin, by using spin coating or the like within the the scope of the invention. In an embodiment, the pixel-defining film 120 may include a light-shielding material, and may be provided in black. The light-shielding material may include carbon black, carbon nanotubes, a resin or paste including a black dye, metal particles (for example, nickel, aluminum, molybdenum, or an alloy thereof), metal oxide particles (for example, chromium oxide), or metal nitride particles (for example, chromium nitride).

The counter electrode 215 may be located on the intermediate layer 213. The counter electrode 215 may include a metal having a low work function, an alloy, an electrically conductive compound, or any combination thereof. For example, the counter electrode 215 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silverytterbium (Ag-Yb), indium tin oxide (ITO), indium zinc oxide (IZO), or any combination thereof. The counter electrode 215 may be a transmissive electrode, a semi-transmissive electrode, or a reflective electrode.

The intermediate layer 213 may include a high molecular weight or low molecular weight organic material emitting light of a given color. The intermediate layer 213 may further include a metal-containing compound such as an organo-metallic compound or an inorganic material such as quantum dots, in addition to various organic materials.

In an embodiment, the intermediate layer 213 may include one emission layer, and a first functional layer and a second functional layer respectively located under or below and over the emission layer. For example, the first functional layer may include a hole transport layer (HTL), or may include a hole transport layer and a hole injection layer (HIL). The second functional layer may include an electron transport layer (ETL) and/or an electron injection layer (EIL). The first functional layer or the second functional layer may be omitted. The first functional layer and the second functional layer may be integrally formed to correspond to a plurality of organic light-emitting diodes OLED included in the display area DA.

In an embodiment, the intermediate layer 213 may include two or more light-emitting units that may be sequentially stacked each other between the pixel electrode 211 and the counter electrode 215, and a charge generation layer CGL located between the two light-emitting units. In case that the intermediate layer 213 may include the light-emitting unit and the charge generation layer CGL, the organic light-emitting diode OLED may be a tandem light-emitting device. Because the organic light-emitting diode OLED has a structure in which a plurality of light-emitting units may be stacked each other, color purity and luminous efficiency may be improved.

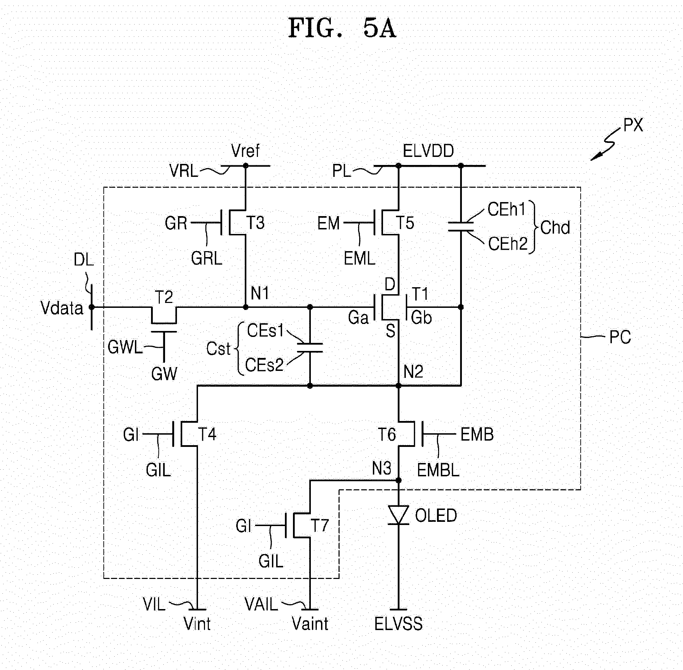

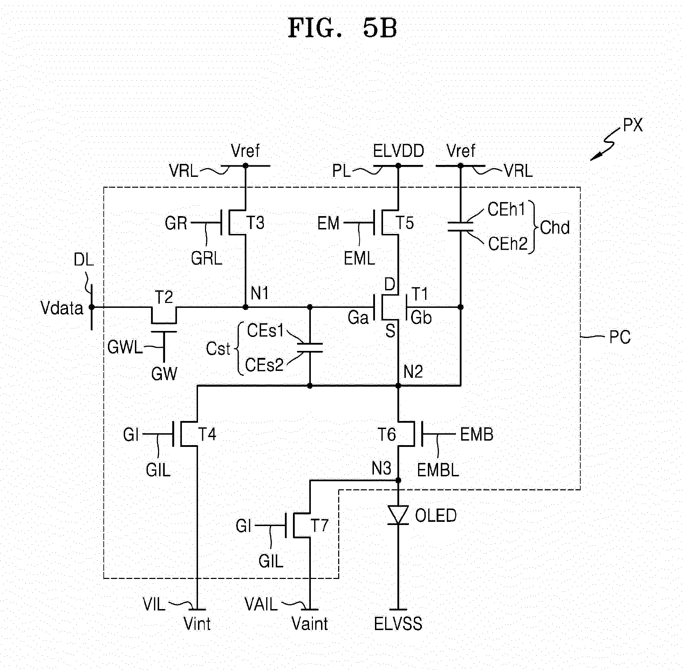

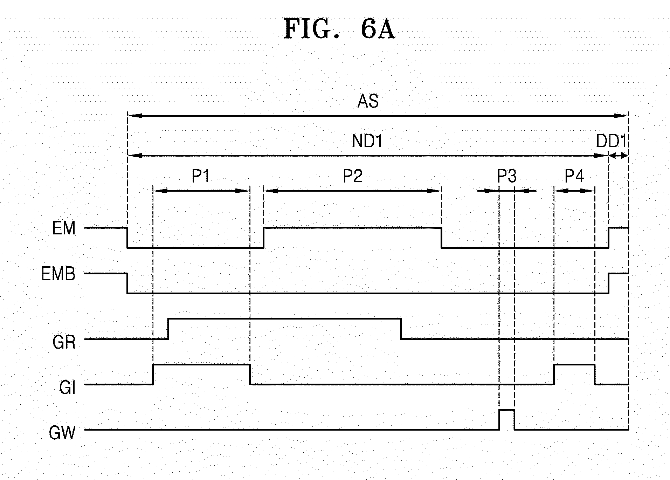

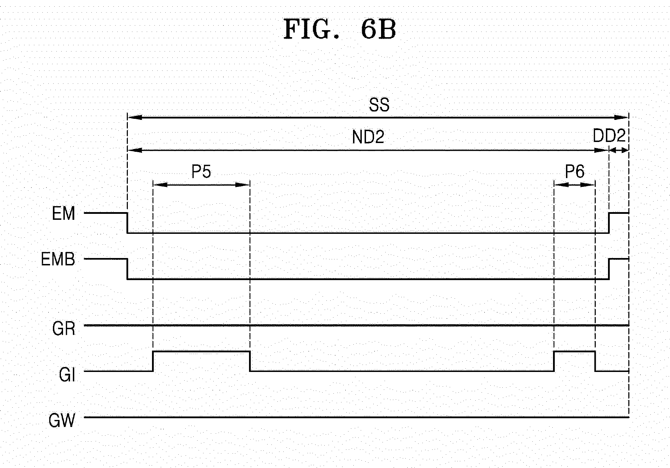

FIGS. 5A and 5B are schematic diagrams of equivalent circuits illustrating a pixel included in a display apparatus, according to an embodiment. FIGS. 6A and 6B are diagrams schematically illustrating signals for describing an operation of the pixel of FIG. 5A.

Referring to FIGS. 5A and 5B, the pixel PX may include the organic light-emitting diode OLED as a display element and the pixel circuit PC connected to the organic light-emitting diode OLED. The pixel circuit PC may include first to seventh transistors T1 to T7, the storage capacitor Cst, and the hold capacitor Chd. The first transistor T1 may be a driving transistor that outputs driving current corresponding to a data signal Vdata, and the second to seventh transistors T2 to T7 may be switching transistors that transmit signals. Each of a first terminal (first electrode) and a second terminal (second electrode) of each of the first to seventh transistors T1 to T7 may be a source or a drain according to voltages of the first terminal and the second terminal. For example, according to voltages of the first terminal and the second terminal, the first terminal may be a drain and the second terminal may be a source, or the first terminal may be a source and the second terminal may be a drain. A node to which an upper gate electrode Ga of the first transistor T1 is connected may be defined as a first node N1, and a node to which a second terminal S of the first transistor T1 is connected may be defined as a second node N2.

The pixel PX may be connected to a first gate line GWL that transmits a first gate signal GW, a second gate signal GIL that transmits a second gate signal GI, a third gate line GRL that transmits a third gate signal GR, a fourth gate line EML that transmits a fourth gate signal EM, a fifth gate line EMBL that transmits a fifth gate signal EMB, and a data line DL that transmits the data signal Vdata. Because light emission of the pixel PX is controlled by the fourth gate signal EM and the fifth gate signal EMB, the fourth gate signal EM and the fifth gate signal EMB may be referred to as emission control signals, and the fourth gate line EML and the fifth gate line EMBL may be referred to as emission control lines.

Also, the pixel PX may be connected to a driving voltage line PL that transmits a first driving voltage ELVDD, a reference voltage line VRL that transmits a reference voltage Vref, a first initialization voltage line VIL that transmits a first initialization voltage Vint, and a second initialization voltage line VAIL that transmits a second initialization voltage Vaint.

The first transistor T1 may include the upper gate electrode Ga, the lower gate electrode Gb, a first terminal D, and the second terminal S connected to the second node N2. The first transistor T1 may include the upper gate electrode Ga connected to the first node N1 and the lower gate electrode Gb connected to the second node N2. The upper gate electrode Ga and the lower gate electrode Gb may be located on different layers to face each other with the second semiconductor layer 1400 (see FIG. 4) therebetween.

The upper gate electrode Ga of the first transistor T1 may be connected to the second terminal of the second transistor T2, the first terminal of the third transistor T3, and the first electrode CEs1 of the storage capacitor Cst. The lower gate electrode Gb of the first transistor T1 may be connected to the first terminal of the sixth transistor T6, the second electrode CEs2 of the storage capacitor Cst, and the fourth electrode CEh2 of the hold capacitor Chd. In an embodiment, the lower gate electrode Gb of the first transistor T1, the second electrode CEs2 of the storage capacitor Cst, and the fourth electrode CEh2 of the hold capacitor Chd may be integrally provided.

The first terminal D of the first transistor T1 may be connected to a driving voltage line PL via the fifth transistor T5, and the second terminal S may be connected to a pixel electrode of the organic light-emitting diode OLED via the sixth transistor T6. The second terminal S of the first transistor T1 may be connected to the first terminal of the fourth transistor T4, the first terminal of the sixth transistor T6, the second electrode CEs2 of the storage capacitor Cst, and the fourth electrode CEh2 of the hold capacitor Chd. The first transistor T1 may receive the data signal Vdata according to a switching operation of the second transistor T2, and may control the amount of driving current flowing to the organic light-emitting diode OLED.

The second transistor T2 (data writing transistor) may be connected between the data line DL and the upper gate electrode Ga of the first transistor T1. The second transistor T2 may include a gate connected to the first gate line GWL, the first terminal connected to the data line DL, and the second terminal connected to the first node N1. The second terminal of the second transistor T2 may be connected to the upper gate electrode Ga of the first transistor T1, the first terminal of the third transistor T3, and the first electrode CEs1 of the storage capacitor Cst. The second transistor T2 may be turned on by the first gate signal GW transmitted through the first gate line GWL to electrically connect the data line DL to the first node N1, and transmit the data signal Vdata transmitted through the data line DL to the first node N1.

The third transistor T3 (first initialization transistor) may be connected to the upper gate electrode Ga of the first transistor T1 and the reference voltage line VRL. The third transistor T3 may include a gate connected to the third gate line GRL, the first terminal connected to the first node N1, and the second terminal connected to the reference voltage line VRL. The first terminal of the third transistor T3 may be connected to the upper gate electrode Ga of the first transistor T1, the second terminal of the second transistor T2, and the first electrode CEs1 of the storage capacitor Cst. The third transistor T3 may be turned on by the third gate signal GR transmitted through the third gate line GRL, to transmit the reference voltage Vref transmitted through the reference voltage line VRL to the first node N1.

The fourth transistor T4 (second initialization transistor) may be connected between the first transistor T1 and the first initialization voltage line VIL. The fourth transistor T4 may include a gate connected to the second gate line GIL, the first terminal connected to the second node N2, and the second terminal connected to the first initialization voltage line VIL. The first terminal of the fourth transistor T4 may be connected to the second terminal S of the first transistor T1, the first terminal of the sixth transistor T6, the second electrode CEs2 of the storage capacitor Cst, and the fourth electrode CEh2 of the hold capacitor Chd. The fourth transistor T4 may be turned on by the second gate signal GI transmitted through the second gate line GIL, to transmit the first initialization voltage Vint transmitted through the first initialization voltage line VIL to the second node N2.

The fifth transistor T5 (first emission control transistor) may be connected between the driving voltage line PL and the first transistor T1. The fifth transistor T5 may include a gate connected to the fourth gate line EML, the first terminal connected to the driving voltage line PL, and the second terminal connected to the first terminal D of the first transistor T1. The fifth transistor T5 may be turned on or turned off according to the fourth gate signal EM transmitted through the fourth gate line EML.

The sixth transistor T6 (second emission control transistor) may be connected between the first transistor T1 and the organic light-emitting diode OLED. The sixth transistor T6 may be connected between the second node N2 and a third node N3. The sixth transistor T6 may include a gate connected to the fifth gate line EMBL, the first terminal connected to the second node N2, and the second terminal connected to the third node N3. The first terminal of the sixth transistor T6 may be connected to the second terminal S of the first transistor T1, the first terminal of the fourth transistor T4, the second electrode CEs2 of the storage capacitor Cst, and the fourth electrode CEh2 of the hold capacitor Chd. The second terminal of the sixth transistor T6 may be connected to the first terminal of the seventh transistor T7 and the pixel electrode of the organic light-emitting diode OLED. The sixth transistor T6 may be turned on or turned off according to the fifth gate signal EMB transmitted through the fifth gate line EMBL.

The seventh transistor T7 (third initialization transistor) may be connected between the organic light-emitting diode OLED and the second initialization voltage line VAIL. The seventh transistor T7 may be connected between the sixth transistor T6 and the second initialization voltage line VAIL. The seventh transistor T7 may include a gate connected to the second gate line GIL, the first terminal connected to the third node N3, and the second terminal connected to the second initialization voltage line VAIL. The first terminal of the seventh transistor T7 may be connected to the second terminal of the sixth transistor T6 and the pixel electrode of the organic light-emitting diode OLED. The seventh transistor T7 may be turned by the second gate signal GI transmitted through the second gate line GIL, to transmit the second initialization voltage Vaint transmitted through the second initialization voltage line VAIL to the third node N3.

The storage capacitor Cst may be connected between the upper gate electrode Ga of the first transistor T1 and the second terminal S of the first transistor T1. The first electrode CEs1 of the storage capacitor Cst may be connected to the first node N1, and the second electrode CEs2 may be connected to the second node N2. The first electrode CEs1 of the storage capacitor Cst may be connected to the upper gate electrode Ga of the first transistor T1, the second terminal of the second transistor T2, and the first terminal of the third transistor T3. The second electrode CEs2 of the storage capacitor Cst may be connected to the second terminal S and the lower gate electrode Gb of the first transistor T1, the fourth electrode CEh2 of the hold capacitor Chd, the first terminal of the fourth transistor T4, and the first terminal of the sixth transistor T6. The storage capacitor Cst that is a storage capacitor may store a voltage corresponding to the data signal Vdata and a threshold voltage of the first transistor T1.

As shown in FIG. 5A, the hold capacitor Chd may be connected between the driving voltage line PL and the second node N2. The third electrode CEh1 of the hold capacitor Chd may be connected to the driving voltage line PL. The fourth electrode CEh2 of the hold capacitor Chd may be connected to the second terminal S and the lower gate electrode Gb of the first transistor T1, the second electrode CEs2 of the storage capacitor Cst, the first terminal of the fourth transistor T4, and the first terminal of the sixth transistor T6. A capacitance of the storage capacitor Cst may be greater than a capacitance of the hold capacitor Chd.

In an embodiment, the hold capacitor Chd may be connected to a constant voltage line having no voltage fluctuation during one frame. For example, as shown in FIG. 5B, the hold capacitor Chd may be connected between the reference voltage line VRL and the second node N2. The third electrode CEh1 of the hold capacitor Chd may be connected to the reference voltage line VRL. The fourth electrode CEh2 of the hold capacitor Chd may be connected to the second terminal S and the lower gate electrode Gb of the first transistor T1, the second electrode CEs2 of the storage capacitor Cst, the first terminal of the fourth transistor T4, and the first terminal of the sixth transistor T6. By way of example, the hold capacitor Chd may be connected between the first initialization voltage line VIL and the second node N2, may be connected between the second initialization voltage line VAIL and the second node N2, or may be connected between the second node N2 and a second driving voltage line to which a second driving voltage ELVSS is applied.

The organic light-emitting diode OLED may be connected to the first transistor T1 through the sixth transistor T6. The organic light-emitting diode OLED may include a pixel electrode (anode) connected to the third node N3 and a counter electrode (cathode) facing the pixel electrode, and the counter electrode may receive the second driving voltage ELVSS. The counter electrode may be a common electrode common to a plurality of pixels PX.

In an embodiment, as described with reference to FIG. 3A, the pixel PX may be driven in one first scan period AS and one second scan period SS during one frame 1F. In an embodiment, as described with reference to FIG. 3B, the pixel PX may be driven in one first scan period AS and two or more second scan periods SS during one frame 1F. Most of the first scan period AS and the second scan period SS may be an emission period. Voltage levels of the first gate signal GW, the second gate signal GI, the third gate signal GR, the fourth gate signal EM, and the fifth gate signal EMB applied to the pixel PX in the first scan period AS and the second scan period SS may be different from each other.

As shown in FIG. 6A, the first scan period AS may include a first non-emission period ND1 in which the pixel PX does not emit light, and a first emission period DD1 in which the pixel PX emits light. The first non-emission period ND 1 may include a first period P1, a second period P2, a third period P3, and a fourth period P4.

Each of the first gate signal GW, the second gate signal GI, the third gate signal GR, the fourth gate signal EM, and the fifth gate signal EMB may have a high-level voltage (first-level voltage) in some periods, and may have a low-level voltage (second-level voltage) in some periods. A high-level voltage may be an on voltage for turning on a transistor, and a low-level voltage may be an off voltage for turning off a transistor.

The first period P1 may be a first initialization period in which the first node N1 and the second node N2 to which the first transistor T1 is connected and the third node N3 to which the pixel electrode of the organic light-emitting diode OLED is connected are initialized. In the first period P1, the second gate signal GI having an on voltage may be supplied (applied) to the second gate line GIL. The third gate signal GR having an on voltage may be supplied to the third gate line GRL. The first gate signal GW, the fourth gate signal EM, and the fifth gate signal EMB each having an off voltage may be supplied. An on voltage application timing of the third gate signal GR may be delayed by a given time from an on voltage application timing of the second gate signal GI.

The fourth transistor T4 and the seventh transistor T7 may be turned on by the second gate signal GI, and the third transistor T3 may be turned on by the third gate signal GR. The second node N2, for example, the second terminal S of the first transistor T1, may be initialized by the turned-on fourth transistor T4 to the first initialization voltage Vint. The first node N1, for example, the upper gate electrode Ga of the first transistor T1, may be initialized by the turned-on third transistor T3 to the reference voltage Vref. The third node N3, for example, the pixel electrode of the organic light-emitting diode OLED, may be initialized by the turned-on seventh transistor T7 to the second initialization voltage Vaint. The storage capacitor Cst and the hold capacitor Chd may be initialized by the turned-on third transistor T3 and fourth transistor T4.

The second period P2 may be a compensation period in which a threshold voltage of the first transistor T1 is compensated. In the second period P2, the third gate signal GR having an on voltage may be supplied to the third gate line GRL, and the fourth gate signal EM may be supplied to the fourth gate line EML. The first gate signal GW, the second gate signal GI, and the fifth gate signal EMB each having an off voltage may be supplied.

The third transistor T3 may be turned on by the third gate signal GR, and the fifth transistor T5 may be turned on by the fourth gate signal EM. Accordingly, the reference voltage Vref may be supplied to the first node N1, and the first driving voltage ELVDD may be supplied to the first terminal D of the first transistor T1, to turn on the first transistor T1. In case that a voltage of the second terminal S of the first transistor T1 is lowered below a difference Vref-Vth between the reference voltage Vref and a threshold voltage Vth of the first transistor T1, the first transistor T1 may be turned off. A voltage corresponding to the threshold voltage Vth of the first transistor T1 may be stored in the storage capacitor Cst, to compensate for the threshold voltage Vth of the first transistor T1.

The third period P3 may be a writing period in which the data signal Vdata is supplied to a pixel PX. In the third period P3, the first gate signal GW having an on voltage may be supplied to the first gate line GWL. The second gate signal GI, the third gate signal GR, the fourth gate signal EM, and the fifth gate signal EMB each having an off voltage may be supplied.

The second transistor T2 may be turned by the first gate signal GW. The turned-on second transistor T2 may transmit the data signal Vdata from the data line DL to the first node N1, for example, the upper gate electrode Ga of the first transistor T1. Accordingly, a voltage of the first node N1 may be changed from the reference voltage Vref to a voltage corresponding to the data signal Vdata. A voltage of the second node N2 may also be changed in response to a voltage change amount of the first node N1. A voltage of the second node N2 may be a voltage (Vref-Vth+α×(Vdata-Vref)) changed according to a capacity ratio (α=Cst/(Cst+Chd)) of the storage capacitor Cst and the hold capacitor Chd. Accordingly, the threshold voltage Vth of the first transistor T1 and a voltage corresponding to the data signal Vdata may be charged in the storage capacitor Cst.

The fourth period P4 is a period after data writing and before the first emission period DD1, and may be a second initialization period in which the second node N2 to which the second terminal S of the first transistor T1 is connected and the third node N3 to which the pixel electrode of the organic light-emitting diode OLED is connected are initialized. In the fourth period P4, the second gate signal GI having an on voltage may be supplied (applied) to the second gate line GIL. The first gate signal GW, the third gate signal GR, the fourth gate signal EM, and the fifth gate signal EMB each having an off voltage may be supplied.

The fourth transistor T4 and the seventh transistor T7 may be turned on by the second gate signal GI. The first initialization voltage Vint may be transmitted to the second terminal S of the first transistor T1 by the turned-on fourth transistor T4. The second initialization voltage Vaint may be transmitted to the pixel electrode of the organic light-emitting diode OLED by the turned-on seventh transistor T7.

In case that a low gray level (for example, 11 to 31) is displayed, a luminance change may occur due to a voltage remaining in the organic light-emitting diode OLED. Because the third node N3 is initialized during the fourth period P4 after data writing and before pixel emission, in case that a low gray level is displayed, a luminance change of the organic light-emitting diode OLED may be minimized, thereby further improving image quality. Also, because the second initialization voltage Vaint is different from the first initialization voltage Vint, for example, higher than the first initialization voltage Vint, a voltage change time of the pixel electrode may be minimized, thereby minimizing screen flickering.

The first emission period DD1 may be a period in which the organic light-emitting diode OLED emits light. In the first emission period DD1, the fourth gate signal EM having an on voltage may be supplied to the fourth gate line EML, and the fifth gate signal EMB having an on voltage may be supplied to the fifth gate line EMBL. Each of the first gate signal GW, the second gate signal GI, and the third gate signal GR may have an off voltage.

In the first emission period DD1, the fifth transistor T5 may be turned on by the fourth gate signal EM, and the first driving voltage ELVDD may be supplied to the first terminal D of the first transistor T1 by the turned-on fifth transistor T5. The first transistor T1 may output driving current (Id∝(Vgs-Vth)²) having a magnitude corresponding to a voltage (Vgs-Vth) obtained by subtracting the threshold voltage Vth of the first transistor T1 from a voltage corresponding to the data signal Vdata stored in the storage capacitor Cst, for example, a gate-source voltage Vgs of the first transistor T1, the driving current may flow to the organic light-emitting diode OLED through the turned-on sixth transistor T6 due to the fifth gate signal EMB, and the organic light-emitting diode OLED may emit light at a luminance corresponding to the magnitude of the driving current.

As shown in FIG. 6B, the second scan period SS may include a second non-emission period ND2 in which the pixel PX does not emit light and a second emission period DD2 in which the pixel PX emits light. The second non-emission period ND2 may include a fifth period P5 and a sixth period P6. The second scan period SS may not include a compensation period corresponding to the second period P2 of the first scan period AS and a writing period corresponding to the third period P3.

Each of the first gate signal GW, the second gate signal GI, the third gate signal GR, the fourth gate signal EM, and the fifth gate signal EMB may have a high-level voltage (first-level voltage) in some periods, and may have a low-level voltage (second-level voltage) in some periods.

The fifth period P5 may be a third initialization period in which the third node N3 to which the pixel electrode of the organic light-emitting diode OLED is connected is initialized. The fifth period P5 may correspond to the first period P1 of the first scan period AS. In the fifth period P5, the second gate signal GI having an on voltage may be supplied to the second gate line GIL. The first gate signal GW, the third gate signal GR, the fourth gate signal EM, and the fifth gate signal EMB each having an off voltage may be supplied. The fourth transistor T4 and the seventh transistor T7 may be turned on by the second gate signal GI. The second node N2, for example, the second terminal S of the first transistor T1, may be initialized by the turned-on fourth transistor T4 to the first initialization voltage Vint. The third node N3, for example, the pixel electrode of the organic light-emitting diode OLED, may be initialized by the turned-on seventh transistor T7 to the second initialization voltage Vaint.

The sixth period P6 is a period before the second emission period DD2, and may be a fourth initialization period in which the third node N3 to which the pixel electrode of the organic light-emitting diode OLED is connected is initialized. The sixth period P6 may correspond to the fourth period P4 of the first scan period AS. In the sixth period P6, the second gate signal GI having an on voltage may be supplied to the second gate line GIL. The first gate signal GW, the third gate signal GR, the fourth gate signal EM, and the fifth gate signal EMB each having an off voltage may be supplied. The fourth transistor T4 and the seventh transistor T7 may be turned on by the second gate signal GI. The second node N2, for example, the second terminal S of the first transistor T1, may be initialized by the turned-on fourth transistor T4 to the first initialization voltage Vint. The third node N3, for example, the pixel electrode of the organic light-emitting diode OLED, may be initialized by the turned-on seventh transistor T7 to the second initialization voltage Vaint.

The second emission period DD2 may be a period in which the organic light-emitting diode OLED emits light. The second emission period DD2 may correspond to the first emission period DD1 of the first scan period AS. In the second emission period DD2, the fourth gate signal EM having an on voltage may be supplied to the fourth gate line EML, and the fifth gate signal EMB having an on voltage may be supplied to the fifth gate line EMBL. Each of the first gate signal GW, the second gate signal GI, and the third gate signal GR may have an off voltage.

In the second emission period DD2, the fifth transistor T5 may be turned on by the fourth gate signal EM, and the first driving voltage ELVDD may be supplied to the first terminal D of the first transistor T1 by the turned-on fifth transistor T5. The first transistor T1 may output driving current having a magnitude corresponding to a voltage stored in the storage capacitor Cst, for example, the data signal Vdata, the driving current may flow to the organic light-emitting diode OLED through the turned-on sixth transistor T6 due to the fifth gate signal EMB, and the organic light-emitting diode OLED may emit light at a luminance corresponding to the magnitude of the driving current. The data signal Vdata stored in the storage capacitor Cst in the second emission period DD2 may be a signal in which a data signal Vdata supplied to the pixel PX in the third period P3 of the first scan period AS is maintained.

In the fourth period P4 and the sixth period P6, in a state where the first initialization voltage Vint and the second initialization voltage Vaint are respectively applied to the second node N2 and the third node N3, for example, the first terminal and the second terminal of the sixth transistor T6, on voltages of the fourth gate signal EM and the fifth gate signal EMB may be applied at the same timing. In an embodiment, in each of the first emission period DD1 and the second emission period DD2, an on voltage application timing of the fifth gate signal EMB may be delayed by a given time from an on voltage application timing of the fourth gate signal EM.

Also, in an embodiment, because initialization of the pixel electrode is performed twice in the second scan period SS, like in the first scan period AS, even in case that one frame may include one or more second scan periods SS, a luminance deviation according to a driving speed may be minimized.

In the above embodiment, because threshold voltage compensation and data writing of a driving transistor are performed once during one frame, the first gate signal GW and the third gate signal GR may be supplied only during the first scan period AS. The second gate signal GI, the fourth gate signal EM, and the fifth gate signal EMB may each be supplied in the first scan period AS and the second scan period SS.

As described with reference to FIG. 3A, in case that one frame 1F may include one first scan period AS and one second scan period SS, the first gate signal GW may be supplied at 1 cycle per frame by being supplied to the pixel PX only once only in the third period P3 of the first scan period AS. The second gate signal GI may be supplied to the pixel PX at 2 cycles per frame by being supplied to the pixel PX twice in the first period P1 and the fourth period P4 of the first scan period AS and supplied to the pixel PX twice in the fifth period P5 and the sixth period P6 of the second scan period SS. The third gate signal GR may be supplied to the pixel PX at 1 cycle per frame by being continuously supplied to the pixel PX once only in the first period P1 and the second period P2 of the first scan period AS. The fourth gate signal EM may be supplied to the pixel PX at 2 cycles per frame by being supplied to the pixel PX once in the first emission period DD1 of the first scan period AS and supplied to the pixel PX once in the second emission period DD2 of the second scan period SS. A case where the fourth gate signal EM is supplied in the second period P2 of the first scan period AS is omitted. The fifth gate signal EMB may be supplied to the pixel PX at 2 cycles per frame by being supplied to the pixel PX once in the first emission period DD1 of the first scan period AS and supplied to the pixel PX once in the second emission period DD2 of the second scan period SS.

In an embodiment, the fourth period P4 of the first scan period AS and the sixth period P6 of the second scan period SS may be omitted. The second gate signal GI may be supplied to the pixel PX at 2 cycles per frame by being supplied to the pixel PX once in the first period P1 of the first scan period AS and supplied to the pixel PX once in the fifth period P5 of the second scan period SS.

As described with reference to FIG. 3B, in an embodiment where one frame may include one first scan period AS and two or more second scan periods SS, the third gate signal GR may be supplied to the pixel PX at 1 cycle per frame and the fourth gate signal EM may be supplied to the pixel PX at 3 or more cycles per frame.

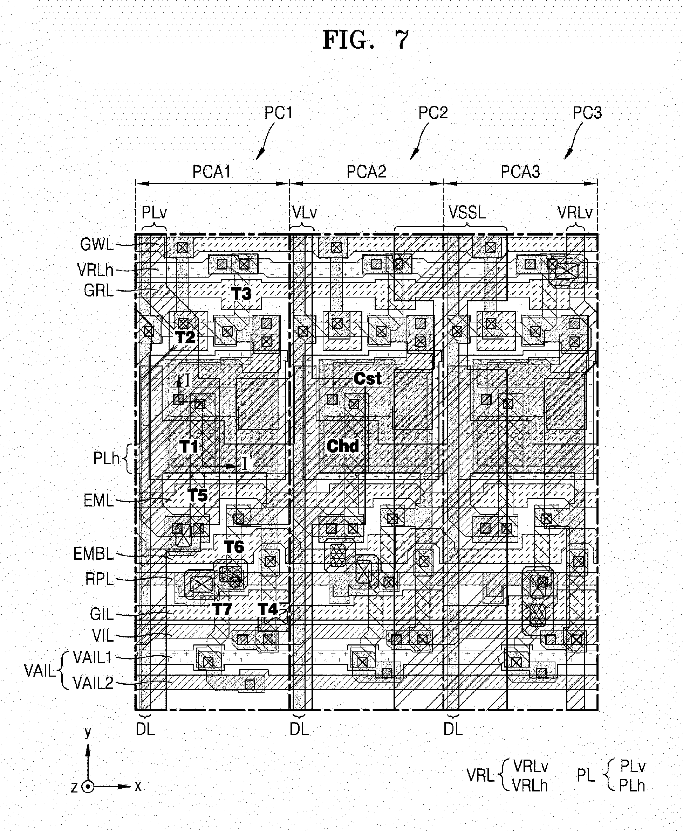

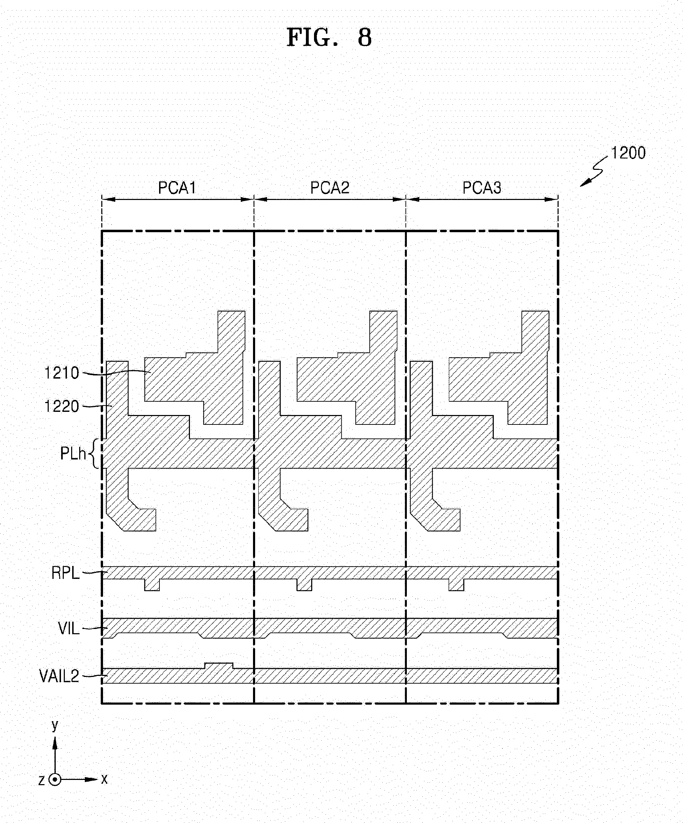

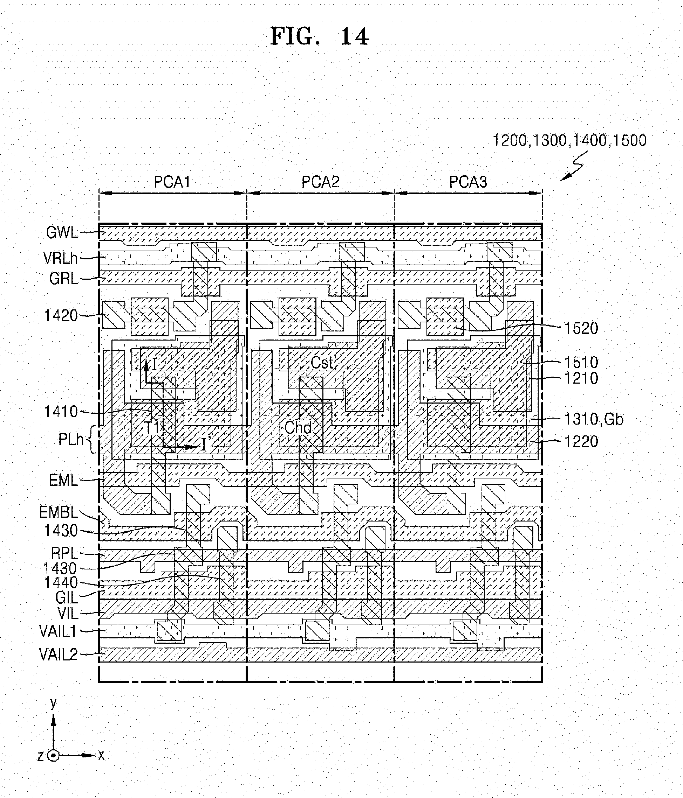

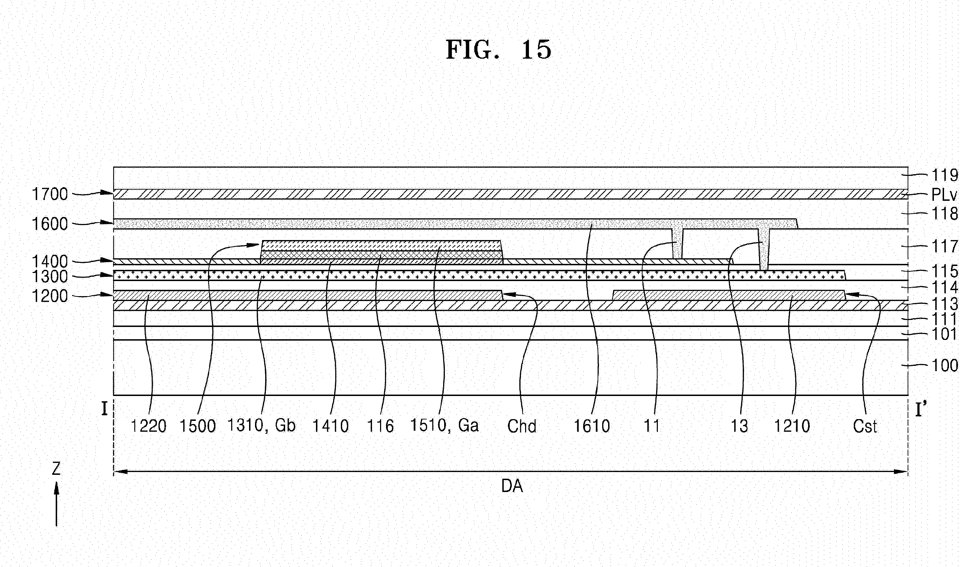

FIG. 7 is a view schematically illustrating an arrangement of a portion of a display apparatus, according to an embodiment. FIGS. 8 to 13 are views schematically illustrating an arrangement of a portion of the display apparatus of FIG. 7 for each layer. FIG. 14 is a view schematically illustrating an arrangement of some or a number of layers of the display apparatus of FIG. 7. FIG. 15 is a schematic cross-sectional view schematically illustrating the display apparatus of FIG. 7, taken along line I-I'.

Referring to FIGS. 7 to 13, the substrate 100 may include a plurality of pixel areas. In an embodiment, a unit pixel area including two or more pixel areas adjacent to each other in a second direction (row direction or x direction) may be defined. For example, the unit pixel area may include a first pixel area PCA1, a second pixel area PCA2, and a third pixel area PCA3 adjacent to each other in the second direction (x direction).

The first pixel area PCA1 may be an area where a first pixel circuit PC1 of a first pixel emitting light of a first color is located. The second pixel area PCA2 may be an area where a second pixel circuit PC2 of a second pixel emitting light of a second color is located. The third pixel area PCA3 may be an area where a third pixel circuit PC3 of a third pixel emitting light of a third color is located. The organic light-emitting diode OLED (see FIG. 4) as a display element may be located directly on a connected pixel circuit to overlap the connected pixel circuit, or may be offset from the connected pixel circuit to partially overlap a pixel circuit of another pixel located in an adjacent row and/or column.

In an embodiment, different second initialization voltages Vaint (e.g. refer to FIG. 5A) may be supplied to the first pixel, the second pixel, and the third pixel, by considering emission characteristics of the first pixel, the second pixel, and the third pixel. For example, the second initialization voltage line VAIL may include a 2-1^{th} initialization voltage line VAIL1 and a 2-2^{th} initialization voltage line VAIL2 to which different second initialization voltages are applied. The first pixel circuit PC1 of the first pixel may be connected to the 2-2^{th} initialization voltage line VAIL2, and each of the second pixel circuit PC2 of the second pixel and the third pixel circuit PC3 of the third pixel may be connected to the 2-1^{th} initialization voltage line VAIL1.

Each of the driving voltage line PL, the reference voltage line VRL, the first initialization voltage line VIL, and the second initialization voltage line VAIL may be a constant voltage line to which a voltage supplied at 1 cycle per frame is applied, or a constant voltage line having no substantial voltage fluctuation during one frame.

In an embodiment, each of the driving voltage line PL, the reference voltage line VRL, the first initialization voltage line VIL, and the second initialization voltage line VAIL may include a first voltage line extending in the second direction (x direction) and a second voltage line extending in a first direction (y direction). The first voltage line and the second voltage line may be connected to each other to form a mesh structure.

For example, the driving voltage line PL may include a first driving voltage line PLh, also called as first voltage line, extending in the second direction (x direction) and a second driving voltage line PLv, also called as second voltage line, extending in the first direction (y direction). The reference voltage line VRL may include a first reference voltage line VRLh, also called as first voltage line, extending in the second direction (x direction) and a second reference voltage line VRLv, also called as second voltage line, extending in the first direction (y direction).

A vertical voltage line VLv formed across the first pixel area PCA1 and the second pixel area PCA2 may be connected to the first initialization voltage line VIL, the 2-1^{th} initialization voltage line VAIL1, or the 2-2^{th} initialization voltage line VAIL2 extending in the second direction (x direction). For example, in case that a first unit pixel area, a second unit pixel area, and a third unit pixel area are sequentially arranged or disposed in the second direction (x direction), the vertical voltage line VLv of the first unit pixel area may be connected to the first initialization voltage line VIL, the vertical voltage line VLv of the second unit pixel area may be connected to the 2-1^{th} initialization voltage line VAIL1, and the vertical voltage line VLv of the third unit pixel area may be connected to the 2-2^{th} initialization voltage line VAIL2.

The same devices may be located on layers of the first pixel area PCA1, the second pixel area PCA2, and the third pixel area PCA3. Hereinafter, for convenience of illustration and explanation, the first pixel area PCA1 will be mainly described, and the same elements in the second pixel area PCA2 and the third pixel area PCA3 as those in the first pixel area PCA1 are denoted by the same reference numerals and a repeated description thereof will be omitted. The following will be described with reference to FIGS. 7 to 15 together.

As shown in FIG. 15, the barrier layer 101, the first insulating layer 111, and the second insulating layer 113 may be sequentially stacked each other on the substrate 100, and a first conductive layer 1200 may be located on the second insulating layer 113. As described with reference to FIG. 4, the second insulating layer 113 may be an insulating layer covering the driving unit semiconductor pattern ACT of the driving unit transistor TR. For example, the first conductive layer 1200 may include the driving unit gate electrode GE of the driving unit transistor TR located in the peripheral area PA. As described above, only an insulating layer including an insulating material may be located between the substrate 100 and the first semiconductor layer 1100 including the driving unit semiconductor pattern ACT.

As shown in FIG. 8, the first conductive layer 1200 may include a first capacitor electrode 1210, a second capacitor electrode 1220, the first initialization voltage line VIL, and the 2-2^{th} initialization voltage line VAIL2. The first capacitor electrode 1210 may correspond to the first electrode CEs1 (see FIG. 4) of the storage capacitor Cst (see FIG. 4), and the second capacitor electrode 1220 may correspond to the third electrode CEh1 (see FIG. 4) of the hold capacitor Chd (see FIG. 4).

The first initialization voltage line VIL and the 2-2^{th} initialization voltage line VAIL2 may extend in the second direction (x direction), to cross the first pixel area PCA1, the second pixel area PCA2, and the third pixel area PCA3.

The first capacitor electrode 1210 and the second capacitor electrode 1220 may be spaced apart from each other. The first capacitor electrode 1210 may be provided in an island type. The first capacitor electrode 1210 may include a connecting portion protruding in the first direction (y direction). The first capacitor electrode 1210 may be connected to a first electrode pattern 1510 through a fourth connection electrode 1640 connected to the connecting portion.

The second capacitor electrode 1220 may be connected to a constant voltage line having no substantial voltage fluctuation during one frame. For example, the second capacitor electrode 1220 may be connected to the first driving voltage line PLh to which the first driving voltage ELVDD (see FIG. 5A) is applied. In an embodiment, the second capacitor electrode 1220 may be connected to the reference voltage line VRL to which the reference voltage Vref (see FIG. 5B) is applied.

The second capacitor electrodes 1220 located in the same row may be connected to each other. The second capacitor electrodes 1220 of the first pixel area PCA1, the second pixel area PCA2, and the third pixel area PCA3 may be connected to each other. For example, as shown in FIG. 8, the second capacitor electrodes 1220 of the first pixel area PCA1, the second pixel area PCA2, and the third pixel area PCA3 and the first driving voltage line PLh may be integrally provided.

In an embodiment, the first conductive layer 1200 may further include a repair line RPL. The repair line RPL may extend in the second direction (x direction), to cross the first pixel area PCA1, the second pixel area PCA2, and the third pixel area PCA3.

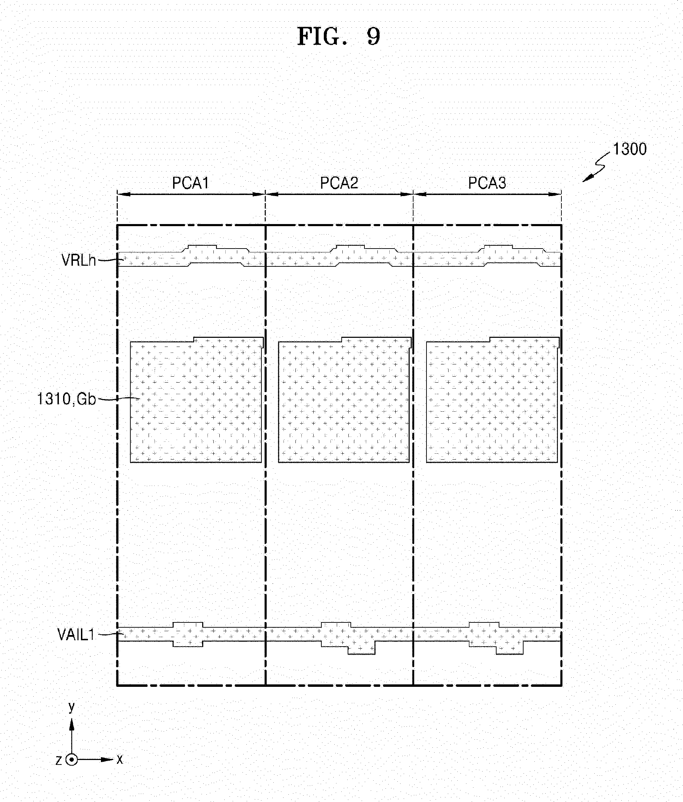

As shown in FIG. 15, the third insulating layer 114 may be located on the first insulating layer 111 (specifically, the second insulating layer 113) to cover the first conductive layer 1200, and a second conductive layer 1300 may be located on the third insulating layer 114. As shown in FIG. 9, the second conductive layer 1300 may include the first reference voltage line VRLh, the 2-1^{th} initialization voltage line VAIL1, and a third capacitor electrode 1310.

The first reference voltage line VRLh and the 2-1^{th} initialization voltage line VAIL1 may extend in the second direction (x direction), and may be located in the first pixel area PCA1, the second pixel area PCA2, and the third pixel area PCA3.

The third capacitor electrode 1310 may be provided in an island type. The third capacitor electrode 1310 may be a T1 source sync back gate. A portion of the third capacitor electrode 1310 overlapping the first capacitor electrode 1210 may correspond to the second electrode CEs2 (see FIG. 4) of the storage capacitor Cst. Another portion of the third capacitor electrode 1310 overlapping the second capacitor electrode 1220 may correspond to the fourth electrode CEh2 (see FIG. 4) of the hold capacitor Chd. A portion of the third capacitor electrode 1310 where the first semiconductor pattern 1410 and the first electrode pattern 1510 overlap each other may correspond to the lower gate electrode Gb of the first transistor T1.

Because a physical distance between the first capacitor electrode 1210 and the third capacitor electrode 1310 and a physical distance between the second capacitor electrode 1220 and the third capacitor electrode 1310 are small, the storage capacitor Cst and the hold capacitor Chd having a sufficient capacitance even in a narrow area may be formed.

As shown in FIG. 15, the fourth insulating layer 115 may be located on the third insulating layer 114 to cover the second conductive layer 1300, and the second semiconductor layer 1400 may be located on the fourth insulating layer 115. The second semiconductor layer 1400 may include an oxide-based semiconductor material.

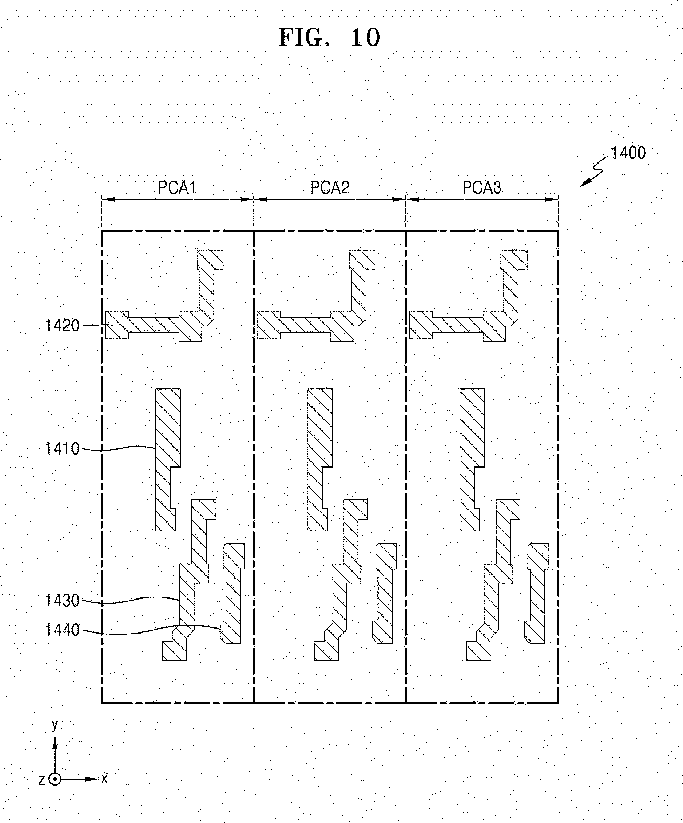

As shown in FIG. 10, the second semiconductor layer 1400 may include the first semiconductor pattern 1410, a second semiconductor pattern 1420, a third semiconductor pattern 1430, and a fourth semiconductor pattern 1440. The second semiconductor layer 1400 may include a channel region, and a source region and a drain region on both sides of the channel region of each of the first to seventh transistors T1 to T7. The source region or the drain region may be shared by transistors located in the same semiconductor pattern, in case that necessary, to replace a source electrode or a drain electrode.

In the third pixel area PCA3, a width (length in the x direction) of the channel region of the first transistor T1 may be greater than a width of the channel region of the first transistor T1 in the first pixel area PCA1 and the second pixel area PCA2.

As shown in FIG. 15, a third conductive layer 1500 may be located on the second semiconductor layer 1400, and the sixth insulating layer 116 may be located between the second semiconductor layer 1400 and the third conductive layer 1500. In an embodiment, only a portion of the sixth insulating layer 116 overlapping the third conductive layer 1500 may remain, and other portions may be removed.

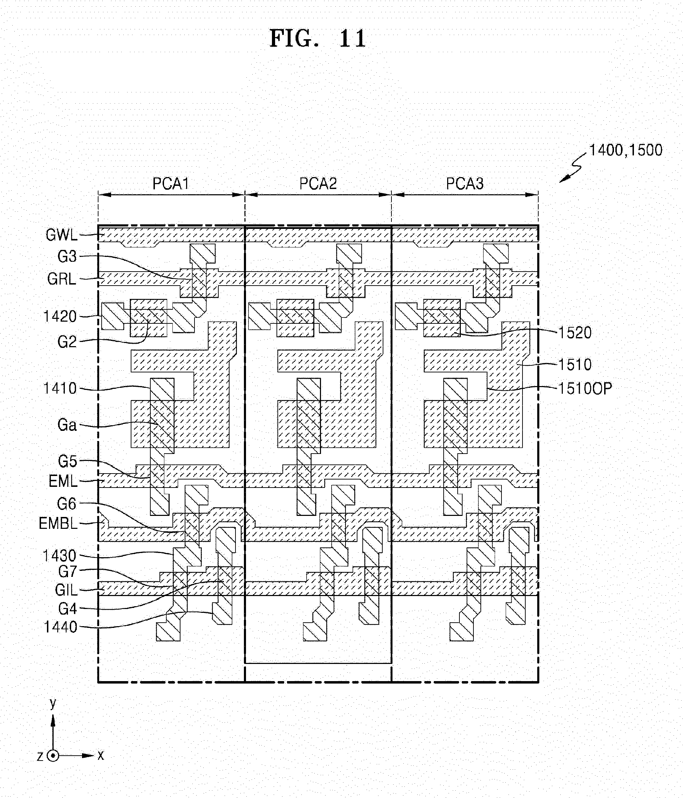

In FIG. 11, for convenience of explanation, the second semiconductor layer 1400 and the third conductive layer 1500 overlap each other. As shown in FIG. 11, the third conductive layer 1500 may include the first electrode pattern 1510, a second electrode pattern 1520, the first gate line GWL, the second gate line GIL, the third gate line GRL, the fourth gate line EML, and the fifth gate line EMBL. The third conductive layer 1500 may include the upper gate electrode Ga of the first transistor T1 and gate electrodes G2 to G7 of the second to seventh transistors T2 to T7.

Referring to FIGS. 7, 10, and 11, the first electrode pattern 1510 may be provided in an island type, and an opening 1510OP may be defined in the first electrode pattern 1510. A first connection electrode 1610 may be connected to the first semiconductor pattern 1410 and the third capacitor electrode 1310 through the opening 1510OP of the first electrode pattern 1510.

A portion of the first electrode pattern 1510 overlapping the first semiconductor pattern 1410 may be the upper gate electrode Ga of the first transistor T1. Another portion of the first electrode pattern 1510 may function as the first electrode CEs1 (see FIG. 4) of the storage capacitor Cst. For example, the first electrode pattern 1510 may include a connecting portion protruding in the second direction (x direction), and the connecting portion of the first electrode pattern 1510 may be connected to the connecting portion of the first capacitor electrode 1210 through the fourth connection electrode 1640.

The second electrode pattern 1520 may be provided in an island type, and a portion of the second electrode pattern 1520 overlapping the second semiconductor pattern 1420 may be the gate electrode G2 of the second transistor T2.

Each of the first gate line GWL, the second gate line GIL, the third gate line GRL, the fourth gate line EML, and the fifth gate line EMBL may extend in the second direction (x direction), and may be located in the first pixel area PCA1, the second pixel area PCA2, and the third pixel area PCA3.

The first gate line GWL may be connected to the second electrode pattern 1520 through a second connection electrode 1620.

The second gate line GIL may overlap the third semiconductor pattern 1430 and the fourth semiconductor pattern 1440. A portion of the second gate line GIL overlapping the third semiconductor pattern 1430 may be the gate electrode G7 of the seventh transistor T7, and a portion of the second gate line GIL overlapping the fourth semiconductor pattern 1440 may be the gate electrode G4 of the fourth transistor T4.

The third gate line GRL may overlap the second semiconductor pattern 1420. A portion of the third gate line GRL overlapping the second semiconductor pattern 1420 may be the gate electrode G3 of the third transistor T3.

The fourth gate line EML may overlap the first semiconductor pattern 1410. A portion of the fourth gate line EML overlapping the first semiconductor pattern 1410 may be the gate electrode G5 of the fifth transistor T5.

The fifth gate line EMBL may overlap the third semiconductor pattern 1430. A portion of the fifth gate line EMBL overlapping the third semiconductor pattern 1430 may be the gate electrode G6 of the sixth transistor T6.

As shown in FIG. 15, the fifth insulating layer 117 may be located on the fourth insulating layer 115 to cover the third conductive layer 1500, and a fourth conductive layer 1600 may be located on the fifth insulating layer 117.

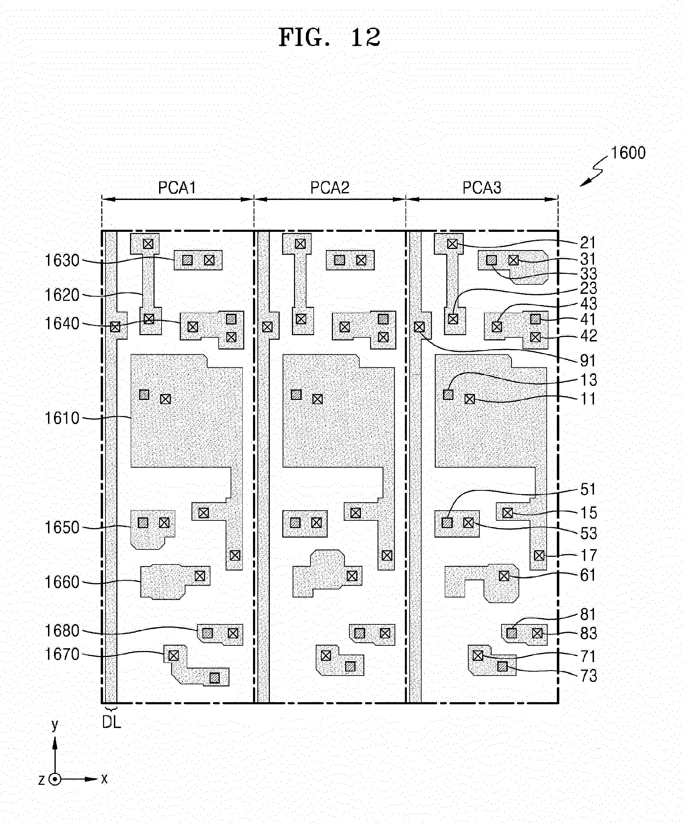

As shown in FIG. 12, the fourth conductive layer 1600 may include the first connection electrode 1610, the second connection electrode 1620, a third connection electrode 1630, the fourth connection electrode 1640, a fifth connection electrode 1650, a sixth connection electrode 1660, a seventh connection electrode 1670, an eighth connection electrode 1680, and the data line DL.

The data line DL may extend in the first direction (y direction) for each pixel area. The data line DL may be connected to the second semiconductor pattern 1420 through a contact hole 91 passing through the fifth insulating layer 117. The data line DL may be connected to the first terminal of the second transistor T2.

Each of the first connection electrode 1610, the second connection electrode 1620, the third connection electrode 1630, the fourth connection electrode 1640, the fifth connection electrode 1650, the sixth connection electrode 1660, the seventh connection electrode 1670, and the eighth connection electrode 1680 may be provided in an island type.

The first connection electrode 1610 may be connected to the first semiconductor pattern 1410 through a contact hole 11 passing through the fifth insulating layer 117, and may be connected to the third capacitor electrode 1310 through a contact hole 13 passing through the fourth insulating layer 115 and the fifth insulating layer 117. The first connection electrode 1610 may be connected to the third semiconductor pattern 1430 through a contact hole 15 passing through the fifth insulating layer 117, and may be connected to the fourth semiconductor pattern 1440 through a contact hole 17 passing through the fifth insulating layer 117. The first connection electrode 1610 may be connected to the second terminal of the first transistor T1, the lower gate electrode Gb of the first transistor T1, the first terminal of the sixth transistor T6, and the first terminal of the fourth transistor T4.

The first connection electrode 1610 may overlap the first electrode pattern 1510. Because the first connection electrode 1610 is connected to the second terminal of the first transistor T1, a capacitance between the first connection electrode 1610 and the first electrode pattern 1510 may be added to a capacitance of the storage capacitor Cst, to increase a storage capacitance of the pixel circuit.

The second connection electrode 1620 may be connected to the first gate line GWL through a contact hole 21 passing through the fifth insulating layer 117, and may be connected to the second electrode pattern 1520 through a contact hole 23 passing through the fifth insulating layer 117. The second connection electrode 1620 may be connected to the first gate line GWL and the gate electrode G2 of the second transistor T2.

The third connection electrode 1630 may be connected to the first semiconductor pattern 1410 through a contact hole 31 passing through the fifth insulating layer 117, and may be connected to the first reference voltage line VRLh through a contact hole 33 passing through the fourth insulating layer 115 and the fifth insulating layer 117. The third connection electrode 1630 may be connected to the first reference voltage line VRLh and the second terminal of the third transistor T3. In any one of unit pixel areas, for example, the third pixel area PCA3, the third connection electrode 1630 may be connected to the second reference voltage line VRLv.

The fourth connection electrode 1640 may be connected to the first capacitor electrode 1210 through a contact hole 41 passing through the third insulating layer 114, the fourth insulating 115, and the fifth insulating layer 117, may be connected to the first electrode pattern 1510 through a contact hole 42 passing through the fifth insulating layer 117, and may be connected to the second semiconductor pattern 1420 through a contact hole 43 passing through the fifth insulating layer 117. The fourth connection electrode 1640 may be connected to the first electrode CEs1 (see FIG. 4) of the storage capacitor Cst, the upper gate electrode Ga of the first transistor T1, the second terminal of the second transistor T2, and the first terminal of the third transistor T3.

The fifth connection electrode 1650 may be connected to the second capacitor electrode 1220 through a contact hole 51 passing through the third insulating layer 114, the fourth insulating layer 115, and the fifth insulating layer 117, and may be connected to the first semiconductor pattern 1410 through a contact hole 53 passing through the fifth insulating layer 117. The fifth connection electrode 1650 may connect the first terminal of the fifth transistor T5 to the first driving voltage line PLh, the second driving voltage line PLv, and the third electrode CEh1 (see FIG. 4) of the hold capacitor Chd.

The sixth connection electrode 1660 may be connected to the third semiconductor pattern 1430 through a contact hole 61 passing through the fifth insulating layer 117. The sixth connection electrode 1660 may connect the second terminal of the sixth transistor T6 and the first terminal of the seventh transistor T7 to the pixel connection electrode CM.

The seventh connection electrode 1670 may be connected to the third semiconductor pattern 1430 through a contact hole 71 passing through the fifth insulating layer 117, and may be connected to the 2-1^{th} initialization voltage line VAIL1 or the 2-2^{th} initialization voltage line VAIL2 through a contact hole 73 passing through the fourth insulating layer 115 and the fifth insulating layer 117. For example, in the first pixel area PCA1, the seventh connection electrode 1670 may be connected to the 2-2^{th} initialization voltage line VAIL2 through the contact hole 73, and in the second pixel area PCA2 and the third pixel area PCA3, the seventh connection electrode 1670 may be connected to the 2-1^{th} initialization voltage line VAIL1 through the contact hole 73. The seventh connection electrode 1670 may connect the second terminal of the seventh transistor T7 to the 2-1^{th} initialization voltage line VAIL1 or the 2-2^{th} initialization voltage line VAIL2.

The eighth connection electrode 1680 may be connected to the first initialization voltage line VIL through a contact hole 81 passing through the third insulating layer 114, the fourth insulating layer 115, and the fifth insulating layer 117, and may be connected to the fourth semiconductor pattern 1440 through a contact hole 83 passing through the fifth insulating layer 117. The eighth connection electrode 1680 may connect the first initialization voltage line VIL to the second terminal of the fourth transistor T4.

As shown in FIG. 15, the seventh insulating layer 118 may be located on the fifth insulating layer 117 to cover the fourth conductive layer 1600, and a fifth conductive layer 1700 may be located on the seventh insulating layer 118. The eighth insulating layer 119 may be located on the seventh insulating layer 118 to cover the fifth conductive layer 1700.

In an embodiment, the first insulating layer 111, the second insulating layer 113, the third insulating layer 114, the fourth insulating layer 115, the fifth insulating layer 117, and the sixth insulating layer 116 may be inorganic insulating layers, and the seventh insulating layer 118 and the eighth insulating layer 119 may be organic insulating layers.

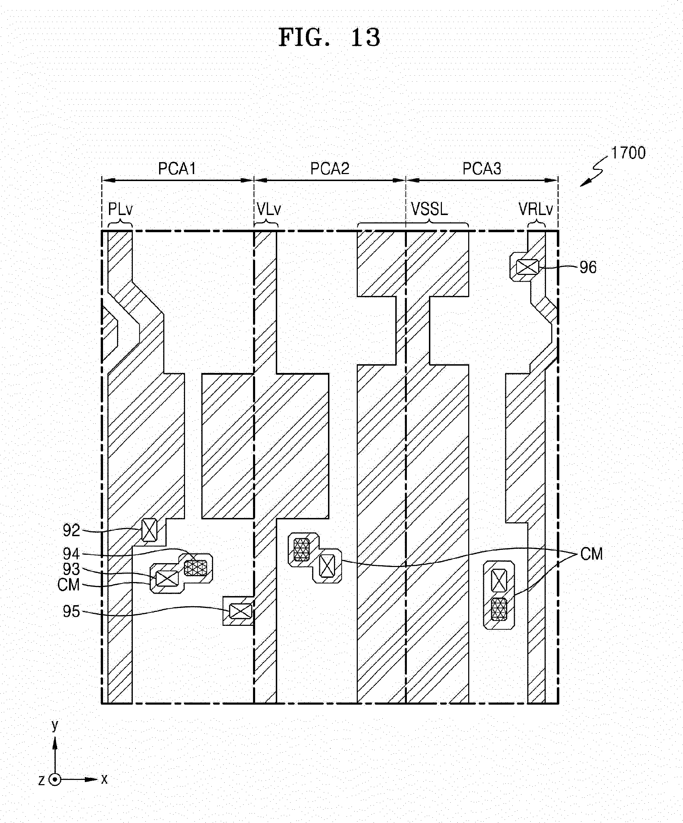

As shown in FIG. 13, the fifth conductive layer 1700 may include the second driving voltage line PLv, the vertical voltage line VLv, a common voltage line VSSL, the second reference voltage line VRLv, and the pixel connection electrode CM.

The pixel connection electrode CM may be connected to the sixth connection electrode 1660 through a contact hole 93 passing through the seventh insulating layer 118, and may be connected to the pixel electrode 211 (see FIG. 4) through a contact hole 94 passing through the eighth insulating layer 119.

In the fifth conductive layer 1700, the second driving voltage line PLv, the vertical voltage line VLv, the common voltage line VSSL, and the second reference voltage line VRLv may extend in the first direction (y direction) and may be spaced apart from each other in the second direction (x direction).

In the unit pixel areas, the second driving voltage line PLv, the vertical voltage line VLv, the common voltage line VSSL, and the second reference voltage line VRLv may be alternately arranged or disposed in the second direction (x direction). The vertical voltage line VLv may be connected to any one of the first initialization voltage line VIL, the 2-1^{th} initialization voltage line VAIL1, and the 2-2^{th} initialization voltage line VAIL2 extending in the second direction (x direction) for each unit pixel area. For example, in FIGS. 7 to 13, the vertical voltage line VLv may be connected to the first initialization voltage line VIL through a contact hole 95 passing through the third insulating layer 114, the fourth insulating layer 115, the fifth insulating layer 117, and the seventh insulating layer 118.

The second driving voltage line PLv may be located in the first pixel area PCA1. The second driving voltage line PLv may be connected to the fifth connection electrode 1650 through a contact hole 92 passing through the seventh insulating layer 118. Accordingly, the second driving voltage line PLv may be electrically connected to the first driving voltage line PLh. The driving voltage line PL may include the first driving voltage line PLh and the second driving voltage line PLv to have a mesh structure in the display area DA. The second driving voltage line PLv may overlap the data line DL located in the first pixel area PCA1.

The vertical voltage line VLv may be located in the first pixel area PCA1 and the second pixel area PCA2. The vertical voltage line VLv may be connected to the first initialization voltage line VIL through the contact hole 95 passing through the third insulating layer 114, the fourth insulating layer 115, the fifth insulating layer 117, and the seventh insulating layer 118. By way of example, the vertical voltage line VLv may be connected to the 2-1^{th} initialization voltage line VAIL1, or may be connected to the 2-2^{th} initialization voltage line VAIL2. A part of the vertical voltage line VLv and the first initialization voltage line VIL may have a mesh structure in the display area DA. Another part of the vertical voltage line VLv and the 2-1^{th} initialization voltage line VAIL1 may have a mesh structure in the display area DA. Another part of the vertical voltage line VLv and the 2-2^{th} initialization voltage line VAIL2 may have a mesh structure in the display area DA. The vertical voltage line VLv may overlap the data line DL located in the second pixel area PCA2.

The common voltage line VSSL may be located in the second pixel area PCA2 and the third pixel area PCA3. The common voltage line VSSL may overlap the data line DL located in the third pixel area PCA3.

The second reference voltage line VRLv may be located in the third pixel area PCA3. The second reference voltage line VRLv may be connected to the third connection electrode 1630 through a contact hole 96 passing through the seventh insulating layer 118. Accordingly, the second reference voltage line VRLv may be electrically connected to the first reference voltage line VRLh. The reference voltage line VRL may include the first reference voltage line VRLh and the second reference voltage line VRLv to have a mesh structure in the display area DA.

In FIG. 14, to describe an arrangement of the storage capacitor Cst, the hold capacitor Chd, and the first transistor T1, only the first conductive layer 1200, the second conductive layer 1300, the second semiconductor layer 1400, and the third conductive layer 1500 are illustrated.

Referring to FIGS. 14 and 15 together, the third capacitor electrode 1310 may overlap the first capacitor electrode 1210 and the second capacitor electrode 1220. The first capacitor electrode 1210 may be the first electrode CEs1 (see FIG. 4) of the storage capacitor Cst, and a portion of the third capacitor electrode 1310 overlapping the first capacitor electrode 1210 may be the second electrode CEs2 (see FIG. 4) of the storage capacitor Cst. The second capacitor electrode 1220 may be the third electrode CEh1 (see FIG. 4) of the hold capacitor Chd, and a portion of the third capacitor electrode 1310 overlapping the second capacitor electrode 1220 may be the fourth electrode CEh2 (see FIG. 4) of the hold capacitor Chd.

The first electrode pattern 1510 may overlap the third capacitor electrode 1310, and the first semiconductor pattern 1410 may be located between the third capacitor electrode 1310 and the first electrode pattern 1510. A portion of the third capacitor electrode 1310 overlapping the first semiconductor pattern 1410 may be the lower gate electrode Gb of the first transistor T1, and a portion of the first electrode pattern 1510 overlapping the first semiconductor pattern 1410 may be the upper gate electrode Ga of the first transistor T1.

An area where the first semiconductor pattern 1410 and the first electrode pattern 1510 overlap each other may be the channel region of the first transistor T1. In a plan view, an area where the first semiconductor pattern 1410 and the first electrode pattern 1510 overlap each other may be located inside the third capacitor electrode 1310. For example, in a plan view, the channel region of the first transistor T1 may be located inside the third capacitor electrode 1310. Because the third capacitor electrode 1310 is located under or below the first semiconductor pattern 1410, photocurrent may be prevented from being caused in the channel region of the first transistor T1 by external light incident on the substrate 100. For example, because the first transistor T1 overlaps the storage capacitor Cst and the hold capacitor Chd, a lower metal layer formed under or below the channel region of the first transistor T1 to block light may be omitted.

Also, the first conductive layer 1200 including the first capacitor electrode 1210 and the second capacitor electrode 1220 may be a layer including the driving unit gate electrode GE (see FIG. 4) of the driving unit transistor TR (see FIG. 4). Also, the second conductive layer 1300 including the third capacitor electrode 1310 may be a layer including the lower gate electrode Gb of the first transistor T1. Accordingly, because a separate conductive layer for forming electrodes of the storage capacitor Cst and the hold capacitor Chd does not need to be formed, the number of masks may be reduced and a process of manufacturing the display apparatus 10 may be further simplified.

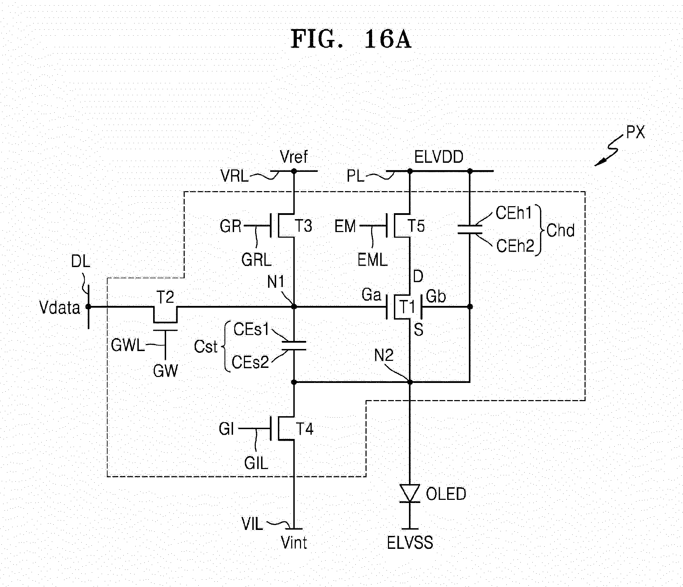

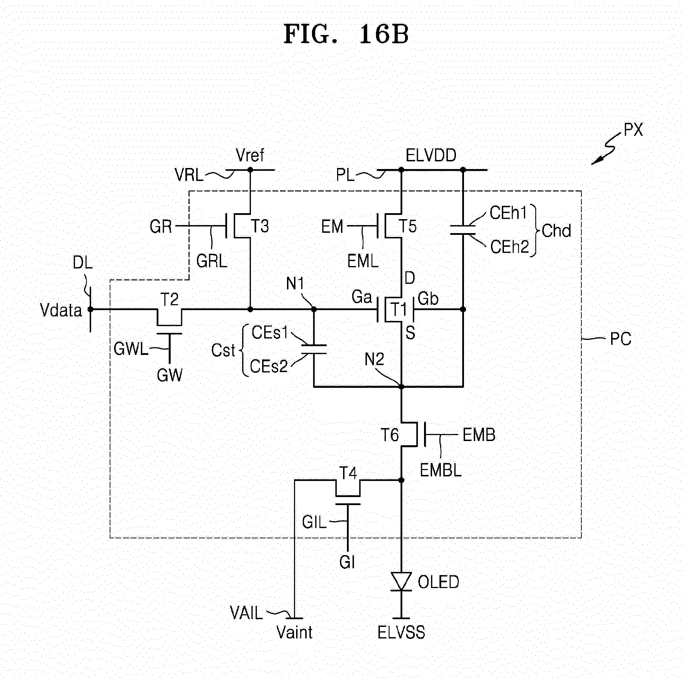

FIGS. 16A and 16B are schematic diagrams of equivalent circuits illustrating a pixel included in a display apparatus, according to an embodiment. FIG. 16A illustrates a case where a pixel circuit of a pixel may include five transistors and two capacitors. FIG. 16B illustrates a case where a pixel circuit of a pixel may include six transistors and two capacitors.

Referring to FIG. 16A, the pixel PX may include the organic light-emitting diode OLED as a display element and the pixel circuit PC connected to the organic light-emitting diode OLED. The pixel circuit PC may include first to fifth transistors T1 to T5, the storage capacitor Cst, and the hold capacitor Chd. The first transistor T1 may be a driving transistor that outputs driving current corresponding to the data signal Vdata, and the second to fifth transistors T2 to T5 may be switching transistors that transmit signals.

A node to which the upper gate electrode Ga of the first transistor T1 is connected may be defined as the first node N1, and a node to which the second terminal S of the first transistor T1 is connected may be defined as the second node N2.

The pixel PX may be connected to the first gate line GWL transmitting the first gate signal GW, the second gate line GIL transmitting the second gate signal GI, the third gate line GRL transmitting the third gate signal GR, the fourth gate line EML transmitting the fourth gate signal EM, and the data line DL transmitting the data signal Vdata. Because light emission of the pixel PX is controlled by the fourth gate signal EM, the fourth gate signal EM may be referred to as an emission control signal, and the fourth gate line EML may be referred to as an emission control line.

Also, the pixel PX may be connected to the driving voltage line PL transmitting the first driving voltage ELVDD, the reference voltage line VRL transmitting the reference voltage Vref, and the first initialization voltage line VIL transmitting the first initialization voltage Vint.

The first transistor T1 may include the upper gate electrode Ga, the lower gate electrode Gb, the first terminal D, and the second terminal S. The first transistor T1 may include the upper gate electrode Ga connected to the first node N1 and the lower gate electrode Gb connected to the second node N2.

The upper gate electrode Ga of the first transistor T1 may be connected to the second terminal of the second transistor T2, the first terminal of the third transistor T3, and the first electrode CEs1 of the storage capacitor Cst. The lower gate electrode Gb of the first transistor T1 may be connected to the first terminal of the fourth transistor T4, the second electrode CEs2 of the storage capacitor Cst, and the fourth electrode CEh2 of the hold capacitor Chd. In an embodiment, the lower gate electrode Gb of the first transistor T1, the second electrode CEs2 of the storage capacitor Cst, and the fourth electrode CEh2 of the hold capacitor Chd may be integrally provided.

The first terminal D of the first transistor T1 may be connected to the driving voltage line PL via the fifth transistor T5, and the second terminal S may be connected to a pixel electrode of the organic light-emitting diode OLED. The second terminal S of the first transistor T1 may be connected to the first terminal of the fourth transistor T4, the second electrode CEs2 of the storage capacitor Cst, and the fourth electrode CEh2 of the hold capacitor Chd. The first transistor T1 may receive the data signal Vdata according to a switching operation of the second transistor T2, and may control the amount of driving current flowing to the organic light-emitting diode OLED.

The second transistor T2 (data writing transistor) may be connected between the data line DL and the upper gate electrode Ga of the first transistor T1. The second transistor T2 may include a gate connected to the first gate line GWL, the first terminal connected to the data line DL, and the second terminal connected to the first node N1. The second terminal of the second transistor T2 may be connected to the upper gate electrode Ga of the first transistor T1, the first terminal of the third transistor T3, and the first electrode CEs1 of the storage capacitor Cst. The second transistor T2 may be turned on by the first gate signal GW transmitted through the first gate line GWL, to electrically connect the data line DL to the first node N1 and transmit the data signal Vdata transmitted through the data line DL to the first node N1.

The third transistor T3 (first initialization transistor) may be connected to the upper gate electrode Ga of the first transistor T1 and the reference voltage line VRL. The third transistor T3 may include a gate connected to the third gate line GRL, the first terminal connected to the first node N1, and the second terminal connected to the reference voltage line VRL. The first terminal of the third transistor T3 may be connected to the upper gate electrode Ga of the first transistor T1, the second terminal of the second transistor T2, and the first electrode CEs1 of the storage capacitor Cst. The third transistor T3 may be turned on by the third gate signal GR transmitted through the third gate line GRL, to transmit the reference voltage Vref transmitted through the reference voltage line VRL to the first node N1.

The fourth transistor T4 (second initialization transistor) may be connected between the first transistor T1 and the first initialization voltage line VIL. The fourth transistor T4 may include a gate connected to the second gate line GIL, the first terminal connected to the second node N2, and the second terminal connected to the first initialization voltage line VIL. The first terminal of the fourth transistor T4 may be connected to the second terminal S of the first transistor T1, the second electrode CEs2 of the storage capacitor Cst, and the fourth electrode CEh2 of the hold capacitor Chd. The fourth transistor T4 may be turned on by the second gate signal GI transmitted through the second gate line GIL, to transmit the first initialization voltage Vint transmitted through the first initialization voltage line VIL to the second node N2.

The fifth transistor T5 (first emission control transistor) may be connected between the driving voltage line PL and the first transistor T1. The fifth transistor T5 may include a gate connected to the fourth gate line EML, the first terminal connected to the driving voltage line PL, and the second terminal connected to the first terminal D of the first transistor T1. The fifth transistor T5 may be turned on or turned off according to the fourth gate signal EM transmitted through the fourth gate line EML.

The storage capacitor Cst may be connected between the upper gate electrode Ga of the first transistor T1 and the second terminal S of the first transistor T1. The first electrode CEs1 of the storage capacitor Cst may be connected to the first node N1, and the second electrode CEs2 may be connected to the second node N2. The first electrode CEs1 of the storage capacitor Cst may be connected to the upper gate electrode Ga of the first transistor T1, the second terminal of the second transistor T2, and the first terminal of the third transistor T3. The second electrode CEs2 of the storage capacitor Cst may be connected to the second terminal S and the lower gate electrode Gb of the first transistor T1, the fourth electrode CEh2 of the hold capacitor Chd, and the first terminal of the fourth transistor T4. The storage capacitor Cst that is a storage capacitor may store a voltage corresponding to the data signal Vdata and a threshold voltage of the first transistor T1.

The hold capacitor Chd may be connected between the driving voltage line PL and the second node N2. The third electrode CEh1 of the hold capacitor Chd may be connected to the driving voltage line PL. The fourth electrode CEh2 of the hold capacitor Chd may be connected to the second terminal S and the lower gate electrode Gb of the first transistor T1, the second electrode CEs2 of the storage capacitor Cst, and the first terminal of the fourth transistor T4. A capacitance of the storage capacitor Cst may be greater than a capacitance of the hold capacitor Chd.

In an embodiment, the hold capacitor Chd may be connected to a constant voltage line having no voltage fluctuation during one frame. For example, the hold capacitor Chd may be connected between the reference voltage line VRL and the second node N2. The third electrode CEh1 of the hold capacitor Chd may be connected to the reference voltage line VRL. The fourth electrode CEh2 of the hold capacitor Chd may be connected to the second terminal S and the lower gate electrode Gb of the first transistor T1, the second electrode CEs2 of the storage capacitor Cst, and the first terminal of the fourth transistor T4. By way of example, the hold capacitor Chd may be connected between the first initialization voltage line VIL and the second node N2, may be connected between the second initialization voltage line VAIL (e.g. refer to FIG. 5A) and the second node N2, or may be connected between the second node N2 and a second driving voltage line to which the second driving voltage ELVSS is applied.

The organic light-emitting diode OLED may be connected to the second terminal S of the first transistor T1. The organic light-emitting diode OLED may include the pixel electrode (anode) connected to the second node N2 and a counter electrode (cathode) facing the pixel electrode, and the counter electrode may receive the second driving voltage ELVSS. The counter electrode may be a common electrode common to a plurality of pixels PX.

In FIG. 16B, the fifth gate line EMBL transmitting the fifth gate signal EMB and the sixth transistor T6 connected between the second node N2 and the first terminal of the fourth transistor T4 may be further provided.

The sixth transistor T6 (second emission control transistor) may be connected between the first transistor T1 and the organic light-emitting diode OLED. The sixth transistor T6 may be connected between the second node N2 and the organic light-emitting diode OLED. The sixth transistor T6 may include a gate connected to the fifth gate line EMBL, the first terminal connected to the second node N2, and the second terminal connected to the organic light-emitting diode OLED. The first terminal of the sixth transistor T6 may be connected to the second terminal S of the first transistor T1, the second electrode CEs2 of the storage capacitor Cst, and the fourth electrode CEh2 of the hold capacitor Chd. The second terminal of the sixth transistor T6 may be connected to the first terminal of the fourth transistor T4 and the pixel electrode of the organic light-emitting diode OLED. The sixth transistor T6 may be turned on or turned off according to the fifth gate signal EMB transmitted through the fifth gate line EMBL.

Instead of being connected to the second node N2, the first terminal of the fourth transistor T4 may be connected to the second terminal of the sixth transistor T6 and the pixel electrode of the organic light-emitting diode OLED.

The invention is not limited thereto, and the number of transistors and capacitors may be changed.

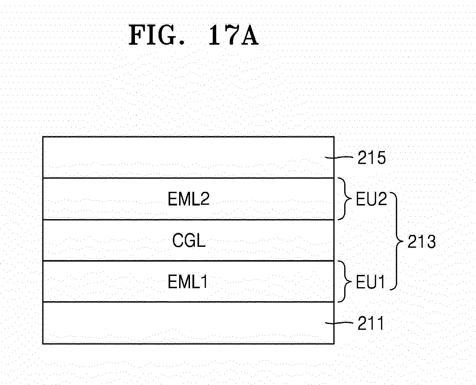

FIGS. 17A to 18B are schematic cross-sectional views illustrating a structure of an organic light-emitting diode included in a display apparatus, according to an embodiment.

The organic light-emitting diode OLED according to an embodiment may include the pixel electrode 211, the counter electrode 215, and the intermediate layer 213 between the pixel electrode 211 (first electrode or anode) and the counter electrode 215 (second electrode or cathode).

The pixel electrode 211 may include a light-transmitting conductive oxide such as indium tin oxide (ITO), indium zinc oxide (IZO), zinc oxide (ZnO), indium oxide (In₂O₃), indium gallium oxide (IGO), or aluminum zinc oxide (AZO). The pixel electrode 211 may include a reflective layer including silver (Ag), magnesium (Mg), aluminum (Al), platinum (Pt), palladium (Pd), gold (Au), nickel (Ni), neodymium (Nd), iridium (Ir), chromium (Cr), or a compound thereof. For example, the pixel electrode 211 may have a three-layer structure including ITO/Ag/ITO.

The counter electrode 215 may be located on the intermediate layer 213. The counter electrode 215 may include a metal having a low work function, an alloy, an electrically conductive compound, or any combination thereof. For example, the counter electrode 215 may include lithium (Li), silver (Ag), magnesium (Mg), aluminum (Al), aluminum-lithium (Al-Li), calcium (Ca), magnesium-indium (Mg-In), magnesium-silver (Mg-Ag), ytterbium (Yb), silverytterbium (Ag-Yb), indium tin oxide (ITO), indium zinc oxide (IZO), or any combination thereof. The counter electrode 215 may be a transmissive electrode, a semi-transmissive electrode, or a reflective electrode.

The intermediate layer 213 may include a high molecular weight or low molecular weight organic material emitting light of a given color. The intermediate layer 213 may further include a metal-containing compound such as an organo-metallic compound or an inorganic material such as quantum dots, in addition to various organic materials.

In an embodiment, the intermediate layer 213 may include one emission layer, and a first functional layer and a second functional layer respectively located under or below and over the emission layer. For example, the first functional layer may include a hole transport layer (HTL), or may include a hole transport layer and a hole injection layer (HIL). The second functional layer may include an electron transport layer (ETL) and/or an electron injection layer (EIL). The first functional layer or the second functional layer may be omitted. The first functional layer and the second functional layer may be integrally formed to correspond to a plurality of organic light-emitting diodes OLED included in the display area DA.

In an embodiment, the intermediate layer 213 may include two or more light-emitting units that may be sequentially stacked each other between the pixel electrode 211 and the counter electrode 215, and a charge generation layer CGL located between the two light-emitting units. In case that the intermediate layer 213 may include the light-emitting unit and the charge generation layer CGL, the organic light-emitting diode OLED may be a tandem light-emitting device. Because the organic light-emitting diode OLED has a structure in which a plurality of light-emitting units may be stacked each other, color purity and luminous efficiency may be improved.

One light-emitting unit may include an emission layer and a first functional layer and a second functional layer respectively located under or below and over the emission layer. The charge generation layer CGL may include a negative charge generation layer and a positive charge generation layer. Due to the negative charge generation layer and the positive charge generation layer, the luminous efficiency of the organic light-emitting diode OLED that is a tandem light-emitting device including a plurality of emission layers may be further improved.

The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply holes. The positive charge generation layer include a host and a dopant. The host may include an organic material. The dopant may include a metal material.

In an embodiment, as shown in FIG. 17A, the organic light-emitting diode OLED may include a first light-emitting unit EU1 including a first emission layer EML1 and a second light-emitting unit EU2 including a second emission layer EML2 which may be sequentially stacked each other. The charge generation layer CGL may be provided between the first light-emitting unit EU1 and the second light-emitting unit EU2. For example, the organic light-emitting diode OLED may include the pixel electrode 211, the first emission layer EML1, the charge generation layer CGL, the second emission layer EML2, and the counter electrode 215 which may be sequentially stacked each other. A first functional layer and a second functional layer may be respectively provided under or below and over the first emission layer EML1. A first functional layer and a second functional layer may be respectively provided under or below and over the second emission layer EML2. The first emission layer EML1 may be a blue emission layer, and the second emission layer EML2 may be a yellow emission layer.

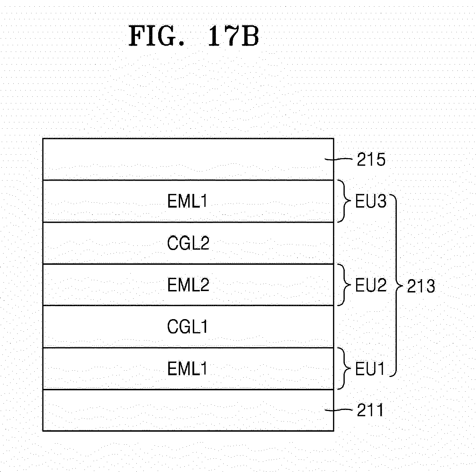

In an embodiment, as shown in FIG. 17B, the organic light-emitting diode OLED may include a first light-emitting unit EU1 and a third light-emitting unit EU3 including a first emission layer EMI,1, and a second light-emitting unit EU2 including a second emission layer EML2. A first charge generation layer CGL1 may be provided between the first light-emitting unit EU1 and the second light-emitting unit EU2, and a second charge generation layer CGL2 may be provided between the second light-emitting unit EU2 and the third light-emitting unit EU3. For example, the organic light-emitting diode OLED may include the pixel electrode 211, the first emission layer EML1, the first charge generation layer CGL1, the second emission layer EMI,2, the second charge generation layer CGL2, the first emission layer EMI,1, and the counter electrode 215 which may be sequentially stacked each other. A first functional layer and a second functional layer may be respectively provided under or below and over the first emission layer EML1. A first functional layer and a second functional layer may be respectively provided under or below and over the second emission layer EMI,2. The first emission layer EML1 may be a blue emission layer and the second emission layer EML2 may be a yellow emission layer.

In an embodiment, in the organic light-emitting diode OLED, the second light-emitting unit EU2 may further include a third emission layer EML3 and/or a fourth emission layer EML4 that is located under or below and/or over the second emission layer EML2 to directly contact the second emission layer EML2, in addition to the second emission layer EML2. Direct contact may mean that there is no layer between the second emission layer EML2 and the third emission layer EML3 and/or between the second emission layer EML2 and the fourth emission layer EML4. The third emission layer EML3 may be a red emission layer, and the fourth emission layer EML4 may be a green emission layer.

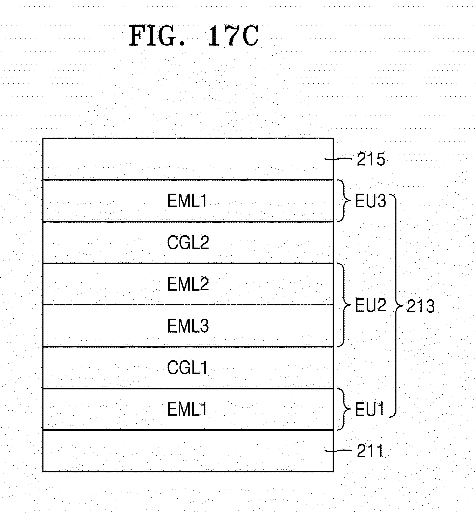

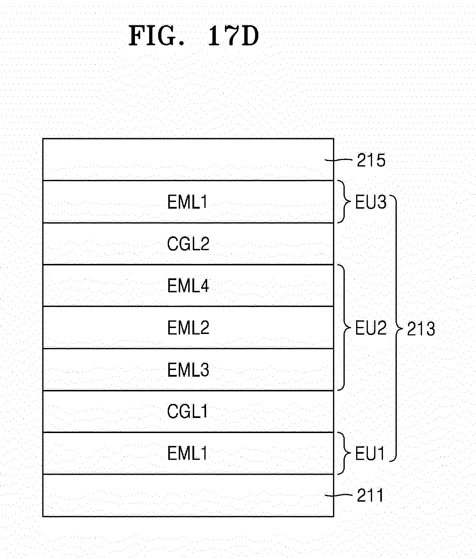

For example, as shown in FIG. 17C, the organic light-emitting diode OLED may include the pixel electrode 211, the first emission layer EML1, the first charge generation layer CGL1, the third emission layer EML3, the second emission layer EML2, the second charge generation layer CGL2, the first emission layer EMI,1, and the counter electrode 215 which may be sequentially stacked each other. By way of example, as shown in FIG. 17D, the organic light-emitting diode OLED may include the pixel electrode 211, the first emission layer EML1, the first charge generation layer CGL1, the third emission layer EML3, the second emission layer EML2, the fourth emission layer EML4, the second charge generation layer CGL2, the first emission layer EMI,1, and the counter electrode 215 which may be sequentially stacked each other.

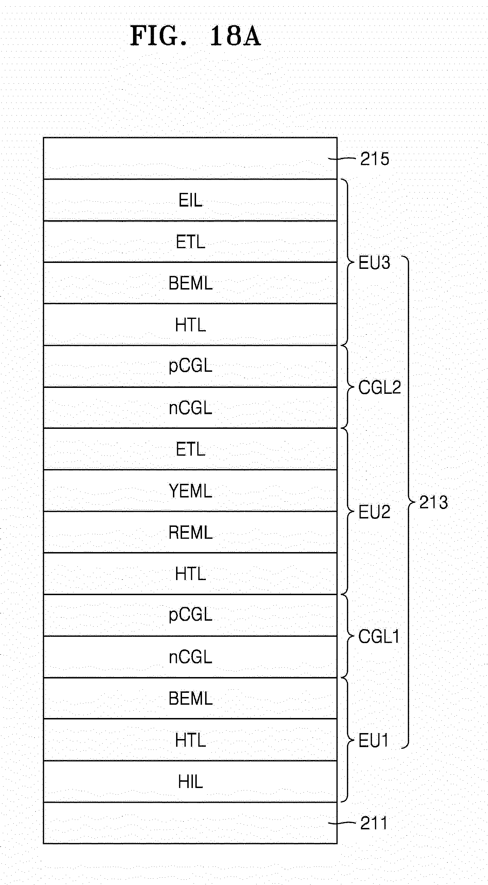

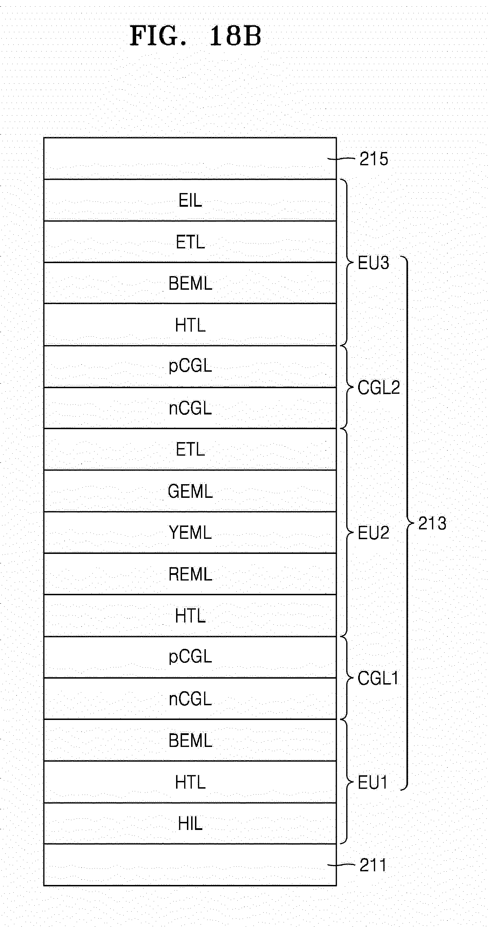

FIG. 18A is a schematic cross-sectional view illustrating the organic light-emitting diode of FIG. 17C. FIG. 18B is a schematic cross-sectional view illustrating the organic light-emitting diode of FIG. 17D.

Referring to FIG. 18A, the organic light-emitting diode OLED may include the first light-emitting unit EU1, the second light-emitting unit EU2, and the third light-emitting unit EU3 which may be sequentially stacked each other. The first charge generation layer CGL1 may be provided between the first light-emitting unit EU1 and the second light-emitting unit EU2, and the second charge generation layer CGL2 may be provided between the second light-emitting unit EU2 and the third light-emitting unit EU3. Each of the first charge generation layer CGL1 and the second charge generation layer CGL2 may include a negative charge generation layer nCGL and a positive charge generation layer pCGL.

The first light-emitting unit EU1 may include a blue emission layer BEML. The first light-emitting unit EU1 may further include a hole injection layer HIL and a hole transport layer HTL between the pixel electrode 211 and the blue emission layer BEML. In an embodiment, a p-doped layer may be further provided between the hole injection layer HIL and the hole transport layer HTL. The p-doped layer may be formed by doping the hole injection layer HIL with a p-type doping material. In an embodiment, at least one of a blue light auxiliary layer, an electron blocking layer, and a buffer layer may be further provided between the blue emission layer BEMI, and the hole transport layer HTL. The blue light auxiliary layer may improve light emission efficiency of the blue emission layer BEML. The blue light auxiliary layer may improve light emission efficiency of the blue emission layer BEMI, by adjusting hole charge balance. The electron blocking layer may prevent electron injection into the hole transport layer HTL. The buffer layer may compensate for a resonance distance according to a wavelength of light emitted from the emission layer.

The second light-emitting unit EU2 may include a yellow emission layer YEMI, and a red emission layer REMI, located under or below the yellow emission layer YEMI, to directly contact the yellow emission layer YEML. The second light-emitting unit EU2 may further include a hole transport layer HTL between the red emission layer REMI, and the positive charge generation layer pCGL of the first charge generation layer CGL1, and may further include an electron transport layer ETL between the yellow emission layer YEMI, and the negative charge generation layer nCGL of the second charge generation layer CGL2.

The third light-emitting unit EU3 may include a blue emission layer BEML. The third light-emitting unit EU3 may further include a hole transport layer HTL between the blue emission layer BEMI, and the positive charge generation layer pCGL of the second charge generation layer CGL2. The third light-emitting unit EU3 may further include an electron transport layer ETL and an electron injection layer EII, between the blue emission layer BEMI, and the counter electrode 215. The electron transport layer ETL may have a single or multilayer structure. In an embodiment, at least one of a blue light auxiliary layer, an electron blocking layer, and a buffer layer may be further provided between the blue emission layer BEMI, and the hole transport layer HTL. At least one of a hole blocking layer and a buffer layer may be further provided between the blue emission layer BEMI, and the electron transport layer ETL. The hole blocking layer may prevent hole injection into the electron transport layer ETL.

The organic light-emitting diode OLED of FIG. 18B is the same as the organic light-emitting diode OLED of FIG. 18A except for a stacked structure of the second light-emitting unit EU2. Referring to FIG. 18B, the second light-emitting unit EU2 may include a yellow emission layer YEML, a red emission layer REMI, located under or below the yellow emission layer YEMI, to directly contact the yellow emission layer YEML, and a green emission layer GEMI, located over the yellow emission layer YEMI, to directly contact the yellow emission layer YEML. The second light-emitting unit EU2 may further include a hole transport layer HTL between the red emission layer REMI, and the positive charge generation layer pCGL of the first charge generation layer CGL1, and may further include an electron transport layer ETL between the green emission layer GEMI, and the negative charge generation layer nCGL of the second charge generation layer CGL2.

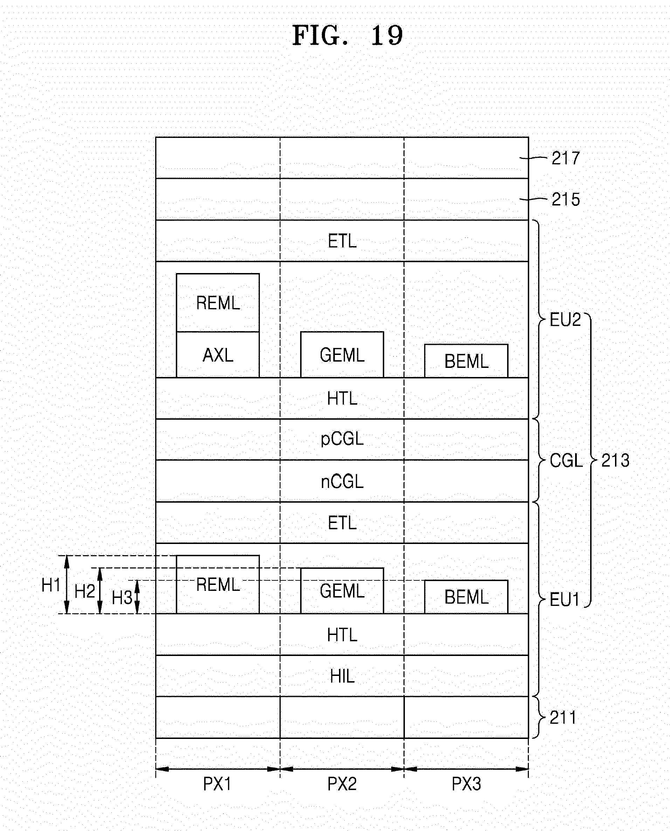

FIG. 19 is a schematic cross-sectional view illustrating structures of organic light-emitting diodes included in a display apparatus, according to an embodiment.

Referring to FIG. 19, a display apparatus may include a plurality of pixels. The plurality of pixels may include a first pixel PX1, a second pixel PX2, and a third pixel PX3. Each of the first pixel PX1, the second pixel PX2, and the third pixel PX3 may include the pixel electrode 211, the counter electrode 215, and the intermediate layer 213. In an embodiment, the first pixel PX1 may be a red pixel, the second pixel PX2 may be a green pixel, and the third pixel PX3 may be a blue pixel. A pixel may include an organic light-emitting diode OLED as a display element, and the organic light-emitting diode OLED of each pixel may be electrically connected to a pixel circuit.

The pixel electrode 211 may be independently provided in the first pixel PX1, the second pixel PX2, and the third pixel PX3.

The intermediate layer 213 of the organic light-emitting diode OLED of each of the first pixel PX1, the second pixel PX2, and the third pixel PX3 may include a first light-emitting unit EU1, a second light-emitting unit EU2, and a charge generation layer CGL between the first light-emitting unit EU1 and the second light-emitting unit EU2, which may be sequentially stacked each other. The charge generation layer CGL may include a negative charge generation layer nCGL and a positive charge generation layer pCGL. The charge generation layer CGL may be a common layer continuously formed in the first pixel PX1, the second pixel PX2, and the third pixel PX3.

The first light-emitting unit EU1 of the first pixel PX1 may include a hole injection layer HIL, a hole transport layer HTL, a red emission layer REML, and an electron transport layer ETL which may be sequentially stacked each other on the pixel electrode 211. The first light-emitting unit EU1 of the second pixel PX2 may include a hole injection layer HIL, a hole transport layer HTL, a green emission layer GEML, and an electron transport layer ETL which may be sequentially stacked each other on the pixel electrode 211. The first light-emitting unit EU1 of the third pixel PX3 may include a hole injection layer HIL, a hole transport layer HTL, a blue emission layer BEML, and an electron transport layer ETL which may be sequentially stacked each other on the pixel electrode 211. Each of the hole injection layer HIL, the hole transport layer HTL, and the electron transport layer ETL of the first light-emitting units EU1 may be a common layer continuously formed in the first pixel PX1, the second pixel PX2, and the third pixel PX3.

The second light-emitting unit EU2 of the first pixel PX1 may include a hole transport layer HTL, an auxiliary layer AXL, a red emission layer REML, and an electron transport layer ETL which may be sequentially stacked each other on the charge generation layer CGL. The second light-emitting unit EU2 of the second pixel PX2 may include a hole transport layer HTL, a green emission layer GEML, and an electron transport layer ETL which may be sequentially stacked each other on the charge generation layer CGL. The second light-emitting unit EU2 of the third pixel PX3 may include a hole transport layer HTL, a blue emission layer BEML, and an electron transport layer ETL which may be sequentially stacked each other on the charge generation layer CGL. Each of the hole transport layer HTL and the electron transport layer ETL of the second light-emitting units EU2 may be a common layer continuously formed in the first pixel PX1, the second pixel PX2, and the third pixel PX3. In an embodiment, in the second light-emitting unit EU2 of the first pixel PX1, the second pixel PX2, and the third pixel PX3, at least one of a hole blocking layer and a buffer layer may be further provided between the emission layer and the electron transport layer ETL.

A thickness H1 of the red emission layer REML, a thickness H2 of the green emission layer GEML, and a thickness H3 of the blue emission layer BEMI, may be determined according to a resonance distance. The auxiliary layer AXL is a layer added to adjust a resonance distance, and may include a resonance auxiliary material. For example, the auxiliary layer AXL may include the same material or a similar material as that of the hole transport layer HTL.

Although the auxiliary layer AXL is provided only in the first pixel PX1 in FIG. 19, an embodiment is not limited thereto. For example, the auxiliary layer AXL may be provided in at least one of the first pixel PX1, the second pixel PX2, and the third pixel PX3 to adjust a resonance distance of each of the first pixel PX1, the second pixel PX2, and the third pixel PX3.

The display apparatus may further include a capping layer 217 located outside the counter electrode 215. The capping layer 217 may improve light emission efficiency due to the principle of constructive interference. Accordingly, the light extraction efficiency of the organic light-emitting diode OLED may be improved, and thus, the light emission efficiency of the organic light-emitting diode OLED may be improved.

According to an embodiment as described above, a display apparatus having improved display quality may be provided. However, the scope of the invention is not limited by this effect. In particular, the invention relates to an HOL PA structure in which only an oxide transistor is located in a display area. A bottom metal layer used to prevent light stains in a conventional HOP structure is omitted, and a T1 source sync back gate in the bottom metal layer is formed in a GAT2 layer. The hold capacitor Chd and the storage capacitor Cst electrodes of GAT1/GAT2 may overlap a driving transistor T1, and the hold capacitor Chd and storage capacitor Cst electrodes may act as a light shield layer.

## Claims

1. A display apparatus (10) comprising:
a substrate (100) comprising a display area (DA) and a peripheral area (PA) adjacent to the display area (DA);
a first semiconductor layer (1100) comprising a driving unit semiconductor pattern (ACT) disposed in the peripheral area (PA);
a first conductive layer (1200) disposed on the first semiconductor layer (1100), and comprising a first capacitor electrode (1210) and a second capacitor electrode (1220) disposed in the display area (DA);
a second conductive layer (1300) disposed on the first conductive layer (1200), and comprising a third capacitor electrode (1310) overlapping the first capacitor electrode (1210) and the second capacitor electrode (1220);
a second semiconductor layer (1400) disposed on the second conductive layer (1300), and comprising a first semiconductor pattern (1410) overlapping the third capacitor electrode (1310);
a third conductive layer (1500) disposed on the second semiconductor layer (1400), and comprising a first electrode pattern (1510) overlapping the first semiconductor pattern (1410) and the third capacitor electrode (1310); and
a fourth conductive layer (1600) disposed on the third conductive layer (1500), and comprising a connection electrode (CM) electrically connected to the first semiconductor pattern (1410) and the third capacitor electrode (1310).

2. The display apparatus (10) of claim 1, wherein the first electrode pattern (1510) is electrically connected to the first capacitor electrode (1210).

3. The display apparatus (10) of claim 1 or 2, wherein an area where the first semiconductor pattern (1410) and the first electrode pattern (1510) overlap each other is disposed inside of the third capacitor electrode (1310) in a plan view.

4. The display apparatus (10) of at least one of claims 1 to 3, further comprising:
a fifth conductive layer (1700) disposed on the fourth conductive layer (1600), and comprising a first voltage line extending in a first direction,
wherein the first conductive layer (1200) comprises a second voltage line electrically connected to the first voltage line and extending in a second direction intersecting the first direction.

5. The display apparatus (10) of at least one of claims 1 to 4, wherein the second capacitor electrode (1220) and the second voltage line are integral.

6. The display apparatus (10) of at least one of claims 1 to 5, wherein
the first semiconductor layer (1100) comprises a silicon semiconductor material, and
the second semiconductor layer (1400) comprises an oxide semiconductor material.

7. The display apparatus (10) of at least one of claims 1 to 6, wherein one or more insulating layers comprising an insulating material are disposed between the first semiconductor layer (1100) and the substrate (100).

8. A display apparatus (10) comprising:
a substrate (100) comprising a display area (DA) and a peripheral area (PA) adjacent to the display area (DA);
a driving unit transistor (TR) disposed in the peripheral area (PA), and comprising a driving unit semiconductor pattern (ACT) and a driving unit gate electrode (GE) overlapping the driving unit semiconductor pattern (ACT);
a first transistor (T1) disposed in the display area (DA), and comprising a first semiconductor pattern (1410) comprising a first terminal (D) and a second terminal (S) and a first electrode pattern (1510) overlapping the first semiconductor pattern (1410);
a second transistor (T2) electrically connected to the first electrode pattern (1510) of the first transistor (T1) and a data line (DL);
a third transistor (T3) electrically connected to the first electrode pattern (1510) of the first transistor (T1) and a reference voltage line (VRL);
a fourth transistor (T5) electrically connected to the first terminal (D) of the first transistor (T1) and a driving voltage line (PL);
a storage capacitor (Cst) comprising a first capacitor electrode (1210) electrically connected to the first electrode pattern (1510) of the first transistor (T1), and a third capacitor electrode (1310) electrically connected to the second terminal (S) of the first transistor (T1) and overlapping the first electrode pattern (1510) of the first transistor (T1); and
a hold capacitor (Chd) comprising a second capacitor electrode (1220) and the third capacitor electrode (1310),
wherein the third capacitor electrode (1310) is disposed on an insulating layer covering the driving unit semiconductor pattern (ACT).

9. The display apparatus (10) of claim 8, wherein an area where the first semiconductor pattern (1410) and the first electrode pattern (1510) overlap each other is disposed inside of the third capacitor electrode (1310) in a plan view.

10. The display apparatus (10) of claim 8 or 9, wherein
the driving voltage line comprises a first voltage line extending in a first direction and a second voltage line extending in a second direction intersecting the first direction, and
the second voltage line and the second capacitor electrode (1220) are integral.

11. The display apparatus (10) of at least one of claims 8 to 10, wherein the driving unit gate electrode (GE), the first capacitor electrode (1210), and the second capacitor electrode (1220) are disposed in a same layer.

12. The display apparatus (10) of at least one of claims 8 to 11, wherein
the third capacitor electrode (1310) is disposed on the first capacitor electrode (1210) and the second capacitor electrode (1220), and
the third capacitor electrode (1310) overlaps the first capacitor electrode (1210) and the second capacitor electrode (1220) in a plan view.

13. The display apparatus (10) of at least one of claims 8 to 12, further comprising:
a connection electrode (CM) that electrically connects the second terminal (S) of the first transistor (T1) to the third capacitor electrode (1310).

14. The display apparatus (10) of claim 13, wherein the connection electrode (CM) overlaps the first electrode pattern (1510).

15. The display apparatus (10) of at least one of claims 8 to 14, further comprising:
a fifth transistor (T4) electrically connected between a first initialization voltage line (VIL) and the second terminal (S) of the first transistor (T1).

16. The display apparatus (10) of at least one of claims 8 to 15, further comprising:
an organic light-emitting diode (OLED) comprising a pixel electrode (211), a counter electrode (215), and an intermediate layer (213) disposed between the pixel electrode (211) and the counter electrode (215); and
a sixth transistor (T6) electrically connected between the second terminal (S) of the first transistor (T1) and the organic light-emitting diode (OLED).

17. The display apparatus (10) of claim 16, further comprising:
a seventh transistor (T7) electrically connected between the organic light-emitting diode (OLED) and a second initialization voltage line (VAIL).

18. The display apparatus (10) of at least one of claims 8 to 17, wherein
the driving unit semiconductor pattern (ACT) comprises a silicon semiconductor material, and
the first semiconductor pattern (1410) comprises an oxide semiconductor material.

19. The display apparatus (10) of at least one of claims 8 to 18, wherein one or more insulating layers comprising an insulating material are disposed between the driving unit semiconductor pattern (ACT) and the substrate (100).

20. The display apparatus (10) of at least one of claims 8 to 19, wherein the second capacitor electrode (1220) is electrically connected to the reference voltage line (VRL).
